# EUROPÄISCHE PATENTSCHRIFT

(11) **EP 3 155 628 B1**
(45) Veröffentlichungstag und Bekanntmachung des Hinweises auf die Patenterteilung: **23.09.2026**
(21) Anmeldenummer: 15724320.5
(22) Anmeldetag: 27.05.2015
(51) Int. Cl.: H01H 47/00, H01H 47/32

(54) **SPULENANORDNUNG SOWIE DAMIT GEBILDETER ELEKTROMECHANISCHER SCHALTER BZW. MESSUMFORMER UND MESSGERÄT**
COIL ARRANGEMENT, AND ELECTRO-MECHANICAL SWITCH OR MEASUREMENT TRANSDUCER AND MEASURING DEVICE FORMED THEREWITH
ENSEMBLE BOBINE ET INTERRUPTEUR ÉLECTROMÉCANIQUE OU CONVERTISSEUR DE MESURE ET APPAREIL DE MESURE CONSTITUÉS À PARTIR DE CELUI-CI

(30) Priorität: 10.06.2014 DE 102014108107
(43) Veröffentlichungstag der Anmeldung: 19.04.2017
(73) Patentinhaber: Endress+Hauser Flowtec AG, 4153 Reinach (BL) (CH)
(72) Erfinder: BRUNNER, Adrian, 4132 Muttenz (CH); BRUDERMANN, Matthias, 4313 Moehlin (CH); WERLE, Christoph, 4410 Liestal (CH)
(74) Vertreter: Endress + Hauser Group Services (Deutschland) AG+Co. KG
(86) Internationale Anmeldenummer: PCT/EP2015/061656
(87) Internationale Veröffentlichungsnummer: WO 2015/189027

(56) Entgegenhaltungen:
- WO-A1-98/24106
- US-A- 4 970 622
- US-A- 5 668 693

## Beschreibung

Die Erfindung betrifft eine mittels einer elektrischen Spule sowie einem zwischen zwei Endlagen bewegbaren Anker gebildete Spulenanordnung. Ferner betrifft die Erfindung einen mittels einer solchen Spulenanordnung gebildeten elektromechanischen Schalter sowie einen Meßumformer bzw. ein Meßgerät mit einem solchen elektromechanischen Schalter.

In der industriellen Meß- und Automatisierungstechnik werden, insb. auch im Zusammenhang mit der Automation chemischer oder verfahrenstechnischer Prozesse und/oder der automatisierten Steuerung von industriellen Anlagen, unmittelbar an der jeweiligen Anlage installierte, gelegentlich auch als Feldmeßgeräte bezeichnete, Meßgeräte, wie z.B. Coriolis-Massendurchfluß-Meßgeräte, Dichte-Meßgeräte, magnetisch-induktive Durchflußmeßgeräte, Wirbel-Durchflußmeßgeräte, Ultraschall-Durchflußmeßgeräte, thermische Massendurchfluß-Meßgeräte, Druck-Meßgeräte, Füllstand-Meßgeräte, Temperatur-Meßgeräte, pH-Wert-Meßgeräte etc., eingesetzt, die der Ermittlung von eine zeitlich veränderliche physikalische und/oder chemische Meßgröße repräsentierenden Meßwerten sowie der Erzeugung von jeweils wenigstes einem nämliche Meßwerte extern des jeweiligen Meßgeräts übertragenden - digitalen oder analogen - Meßwertsignal dienen. Bei der mittels des jeweiligen Meßgeräts jeweils zu erfassenden Meßgröße kann es sich, je nach Anwendung, beispielsweise um einen Massendurchfluß, eine Dichte, eine Viskosität, einen Füll- oder einen Grenzstand, einen Druck, ein pH-Wert, eine elektrische Leitfähigkeit oder eine Temperatur oder dergleichen, eines flüssigen, pulver-, dampf- oder gasförmigen Mediums handeln, das in einem entsprechenden Behälter, wie z.B. einer Rohrleitung oder einem Tank, geführt bzw. vorgehalten wird. Solche, dem Fachmann an und für sich bekannte Meßgeräte sind u.a. in der EP-A 1 591 977, der GB-A 22 29 897, der US-A 2001/0016802, der US-A 2010/0026322, der US-A 2011/0062942, der US-A 56 72 975, der US-A 60 14 100, der US-A 61 40 940, der US-B 64 52 493, der US-B 64 72 884, der US-B 66 84 340, der US-B 71 62 651, der US-B 72 96 482, der US-B 76 30 844, der US-B 77 78 784, der US-B 77 92 646, WO-A 00/26739, der WO-A 00/48157, der WO-A 01/71291, der WO-A 03/106931, der WO-A 2008/091548, der WO-A 2009/002341, der WO-A 2011/005938, der WO-A 2012/009003, der WO-A 2012/159683, der WO-A 2012/163608, der WO-A 88/02476, der WO-A 88/02853, der WO-A 94/20940, der WO-A 95/08123 , der WO-A 95/08758 oder auch der eigenen, nicht vorveröffentlichten internationalen Anmeldung PCT/EP2013/074632 gezeigt bzw. werden von der Anmelderin selbst, beispielsweise unter der Bezeichnung t-trend ATT12, Flowphant T DTT31, Promag 53H, Prowirl 73F, Promass E 200, Promass F 200, Promass 83X, oder Promass 84F, gewerblich angeboten.

Meßgeräte der vorbezeichneten Art sind typischerweise durch Zusammenschluß eines dem Erfassen der jeweiligen Prozeßgrößen dienenden physikalisch-elektrischen oder chemischelektrischen Meßaufnehmers und eines mit diesem elektrisch gekoppelten Meßumformers (Transmitter) gebildet. Nämlicher Meßaufnehmer ist zumeist dafür ausgestaltet, in eine Wandung des das Medium jeweils führenden Behälters oder der in den Verlauf einer das Medium jeweils führenden Leitung, beispielsweise eine Rohrleitung, eingesetzt zu werden und wenigstens ein mit der zu erfassenden Meßgröße entsprechend korrespondierendes, nämlich deren zeitlichen Verlauf repräsentierenden zunächst analoges elektrisches Aufnehmersignal zu generieren, das wiederum mittels einer an den Meßaufnehmer elektrisch angeschlossenen Umformer-Elektronik des jeweiligen Meßumformers weiterverarbeitet werden kann, derart, daß im Betrieb des Meßgeräts mittels der Umformer-Elektronik entsprechende Meßwerte für die Meßgrößen ermittelt werden. Die Umformer-Elektronik eines industrietauglichen Meßgeräts ist zumeist in einem vergleichsweise robusten, etwa schlag-, druck-, explosions- und/oder wetterfesten, Umformer-Gehäuse untergebracht. Dieses kann z.B. vom Meßaufnehmer entfernt angeordnet und mit diesem nur über eine flexible Leitung verbunden sein; es kann aber auch direkt am Meßaufnehmer bzw. an einem den Meßaufnehmer separat einhausenden Meßaufnehmer-Gehäuse angebracht sein.

Zum Verarbeiten des Aufnehmersignals, insb. nämlich zum Erzeugen von die jeweilige Meßgröße repräsentierenden digitalen Meßwerten sowie zum Umwandeln nämlicher Meßwerte in zumindest ein extern des Meßumformer bzw. des damit gebildeten Meßgeräts übertrag- und auswertbares Meßwertesignal, weist die Umformer-Elektronik ferner eine entsprechende Meßschaltung auf. Wie u.a. auch in der eingangs erwähnten US-A 2001/0016802, US-A 2010/0026322, US-A 2011/0062942, US-B 76 30 844, US-B 77 92 646, US-B 77 78 784, US-B 64 52 493, US-A 60 14 100, WO-A 95/08123 oder WO-A 2012/009003 jeweils gezeigt, sind nämliche Meßschaltungen bei modernen Meßgeräten der in Rede stehenden Art zumeist mittels eines Mikroprozessors gebildet, dem über einen entsprechenden Signaleingang das - beispielsweise mittels eines separaten Analog-zu-Digital-Wandlers vorab bereits digitalisierte - Aufnehmersignal zugeführt ist. Nämlicher Mikroprozessor ist u.a auch dafür vorgesehen, basierend auf dem (ggf. vorab digitalisierten) Aufnehmersignal am Signaleingang eine Meßwertefolge, nämlich eine einen zeitlichen Verlauf der Meßgröße repräsentierende Sequenz von für verschiedene Zeitpunkte gewonnenen, die Meßgröße jeweils momentan repräsentierenden digitalen Meßwerten zu generieren. Die mittels der Meßschaltung generierten Meßwerte werden inform von elektrischen - digitalen oder analogen - Meßwertsignalen an gleichermaßen innerhalb des Umformer-Gehäuses plazierten, jeweils als Schnittstelle fungierenden Schaltungsausgängen bereitgestellt, beispielsweise inform eines im Bereich von 4-20 mA entsprechend modulierten analogen Signalstroms. Darüberhinaus sind auch sogenannte Frequenzausgänge, nämlich die Meßwerte in eine Pulsfolgefrequenz eines binären Rechtecksignals codierende Schaltungsausgänge, oder auch sogenannte Impulsausgänge, nämlich das Erreichen einer vorab wählbaren, quantisierten Mengeneinheit inform eines Impulses signalisierende Schaltungsausgänge, zur Bereitstellung von Meßwerten üblich.

Meßgeräte der in Rede stehenden Art können zusätzlich oder alternativ zu Meßwertsignale bereitstellenden Schaltungsausgängen auch solche - gelegentlich auch als Schalt- oder Relaisausgang bezeichnete - Schaltungsausgänge aufweisen, die dafür eingerichtet sind, einen teilweise extern des Meßgeräts verlaufenden, gelegentlich auch als Laststromkreis bezeichneten, Stromkreis wahlweise zu- bzw. abzuschalten bzw. ein - zumeist binäres - Signal auszugeben, etwa inform eines Status-Signals zur Vermeidung eines Betriebszustandes des jeweiligen Meßgeräts und/oder zur Übermittlung einer Fehlermeldung bzw. eines Alarms an eine entfernte Meldeeinrichtung oder inform eines dem Signalisieren eines Erreichens eines vorgegeben Schwellenwerts und/oder dem unmittelbaren Ansteuern von an das Meßgerät angeschlossenen externen elektrischen Geräten, beispielsweise eines weiteren Meßgeräts oder aber auch eines Ventils, einer Pumpe oder eines Motors, dienenden Schalt-Signals. Derartige Schaltausgänge können beispielsweise mittels eines elektronischen Halbleiterschaltelements, wie z.B. mittels eines Transistors oder eines Thyristors, gebildet bzw. als Halbleiterrelais (Solid-State-Relais) ausgebildet sein; sehr verbreitet sind aber nach wie vor auch solche Schaltausgänge, die mittels eines innerhalb des Umformer-Gehäuses plazierten und mit der Umformer-Elektronik elektrisch verbundenen bzw. davon angesteuerten elektro-mechanischen Relais, mithin mittels eines elektro-mechanischen Schalters gebildet sind.

Solche in Schaltungsausgängen von Meßumformern eingesetzten elektro-mechanischen Schalter bzw. Relais weisen jeweils eine mittels wenigstens einer elektrischen Spule gebildete Spulenanordnung sowie einen damit, mithin mechanisch betätigten, zwischen einer ersten Endlage und einer zweiten Endlage bewegbaren ersten Schaltkontakt und einen zweiten Schaltkontakt auf. Nämlicher erster Schaltkontakt ist zwecks Realisierung zweier unterschiedlicher Schaltstellungen dafür eingerichtet, in erster Schaltstellung vom zweiten Schaltkontakt unter Bildung einer hochohmigen bzw. elektrisch isolierenden Luftstrecke beabstandet zu sein, und in zweiter Schaltstellung den zweiten Schaltkontakt unter Bildung einer niederohmigen bzw. elektrisch leitfähigen Verbindung zu berühren. Die Spule der Spulenanordnung weist einen Spulenkern sowie einen nämlichen Spulenkern umgebenden Stromleiter auf. Mittels des Spulenkerns sowie eines zwischen einer ersten Endlage und einer zweiten Endlage bewegbaren, beispielsweise dauermagnetischen und/oder aus einem Metall bestehenden, Ankers der Spulenanordnung ist ferner ein Magnetkreis gebildet, wobei die Spule dafür vorgesehen ist, im Stromleiter einen elektrischen Strom zu führen und nämlichen Strom in eine zwischen deren Spulenkern und dem Anker wirkende Magnetkraft zum Bewegen des Ankers zu wandeln, und wobei der Anker dafür vorgesehen ist, bei einem Wechsel aus dessen erster Endlage in dessen zweite Endlage den ersten Schaltkontakt aus dessen erster Schaltstellung in dessen zweite Schaltstellung zu bewegen, mithin den elektro-mechanischen Schalter zu betätigen.

Spulenanordnungen der vorbezeichneten Art, insb. nämlich als Bestandteil eines Schaltungsausgangs eines Meßumformers ausgebildete Spulenanordnungen, umfassen ferner einen elektrisch gesteuert zwischen wenigstens zwei Schaltzuständen umschaltbaren, beispielsweise mittels wenigstens eines elektronischen Halbleiterelements, wie etwa einem Transistor gebildeten, elektronischen Schalter sowie eine, beispielsweise auch im Verbund vorbezeichneten Meßschaltung, nämlich auch mittels deren ggf. vorhanden Mikroprozessors gebildete, Steuerschaltung zum Erzeugen eines nämlichen elektronischen Schalter betätigenden Schaltsignals mit einem veränderlichen Signalpegel, derart, daß das Schaltsignal zeitweise mit einem einen ersten Schaltzustand des elektronischen Schalters veranlassenden ersten Signalpegelwert ("H") bzw. das Schaltsignal zeitweise mit einem einen zweiten Schaltzustand des elektronischen Schalters veranlassenden, vom ersten Signalpegelwert verschiedenen zweiten Signalpegelwert ("L") bereitzustellen. Der elektronischen Schalter wiederum ist dafür vorgesehen, in seinem ersten Schaltzustand einen damit und mittels der Spule gebildeten Spulen-Stromkreis zu schließen, derart, daß ein einem dann im Betrieb-in nämlichem Spulen-Stromkreis fließenden elektrischen Strom entgegenwirkender elektrischer Widerstand des Stromkreises dann einen niederohmigen ersten Widerstandswert aufweist, und in seinem zweiten Schaltzustand nämlichen Spulen-Stromkreis zu öffnen, derart, daß dessen elektrischer Widerstand dann einen hochohmigen zweiten Widerstandswert, der größer als der erste Widerstandswert ist, aufweist. Die Meßschaltung ist ferner dafür vorgesehen, ein die Steuerschaltung instruierendes, nämlich eine Änderung des Signalpegels des Schaltsignals vom ersten Signalpegel auf den zweiten Signalpegel oder eine Änderung des Signalpegels des Schaltsignals vom ersten Signalpegel auf den zweiten Signalpegel veranlassendes, Steuersignal zu generieren, beispielsweise auch unter Verwendung des Aufnehmersignals und/oder in Abhängigkeit zumindest eines der Meßwerte.

Vorteile eines solchen mittels eines elektro-mechanischen Relais bzw. Schalters gebildeten Schaltungsausgangs sind neben dem relativ kostengünstigen Aufbau u.a. darin zu sehen, daß konstruktionsbedingt zum einen zwischen der Steuerschaltung bzw. der damit gebildeten Umformer-Elektronik (Steuerstromkreis) sowie dem mittels der beiden Schaltkontakte geschalteten extern des Meßgeräts verlaufenden Stromkreis (Laststromkreis) eine galvanische Trennung, einhergehend mit einem hohen Isolationswiderstand bzw. einer hohe Spannungsfestigkeit der so gebildeten Trennstrecke, und zum anderen ein Schalter mit sehr hohem Kontaktübergangswiderstand in geöffneter erster Schaltstellung bzw. sehr niederohmigen Kontaktübergangswiderstand in geschlossener zweiter Schaltstellung, mithin mit einer guten Unterscheidbarkeit der beiden Schaltzustände realisiert werden können. Darüberhinaus kann regelmäßig mittels eines elektromechanischen Relais im Laststromkreis eine im Vergleich zur in der Steuerschaltung, mithin im Steuerstromkreis umgesetzten elektrischen Leistung sehr hohe elektrische Leistung geschaltet bzw. ein Schaltungsausgang mit hoher Überlastbarkeit und/oder hoher Kurzschlußfestigkeit bereitgestellt werden. Elektromechanische Relais bzw. damit gebildete Schaltungsausgänge zeichnen sich zudem regelmäßig auch durch eine hohe elektromagnetische Verträglichkeit (EMV) sowie eine hohe Störfestigkeit, auch gegen elektrostatische Entladung (ESD) aus.

Ein Nachteil eines elektro-mechanischer Relais bzw. damit gebildeten Schalters besteht allerdings u.a. darin, daß dessen prinzipbedingt beweglichen Komponenten, nämlich der Anker sowie die Schaltkontakte, auch bei spezifikationsgemäßer Belastung mechanisch verschleißen, mithin solche elektromechanischen Schalter nur einen im Vergleich zu Halbeiterrelais naturgemäß erheblich geringeren Vorrat an möglichen Schaltspielen bzw. nominell eine vergleichsweise niedrigere maximale Schaltspielzahl aufweisen. Darüberhinaus kann sich zudem auch der anfänglich sehr niederohmige Kontaktübergangswiderstand eines solchen Schalters in dessen geschlossener (zweiter) Schaltstellung in Abhängigkeit von den im Betrieb geschalteten elektrischen Leistungen ändern, derart, daß nämlicher Kontaktübergangswiderstand mit zunehmender Betriebsdauer bzw. zunehmender Schaltspielzahl in unerwünschter Weise zunimmt. Als weitere, die Funktionstüchtigkeit des jeweiligen elektro-mechanischen Schalter bzw. des damit gebildeten Schaltungsausgangs beeinträchtigende Belastungen sind allfällige Erschütterungen bzw. Vibrationen der Umformer-Elektronik zu nennen.

Ungünstige Konstellationen solcher, regelmäßig von der Umformer-Elektronik selbst nicht detektierbaren Belastungen oder ggf. auch über vorab spezifizierte Grenzwerte hinausgehende, gleichermaßen nicht detektierte Überbelastungen von elektro-mechanischen Relais bzw. einem damit gebildeten Schaltungsausgang können ggf. sogar zu einem Totalausfall nämlichen Relais führen, beispielsweise nämlich derart, daß der Anker des Relais - gelegentlich oder ständig - trotz eines Wechsels des Steuersignals von einem Signalpegelwert auf einen anderen in einer eingenommen Endlage verharrt, beispielsweise infolge eines Verklemmens von Anker und damit betätigtem Schaltkontakt, durch Deformation oder Wegbrechen des Ankers oder infolge eines Verschweißens oder Verklebens der beiden Schaltkontakte. Infolgedessen kann der dem Laststromkreis des Relais entsprechende extern des Meßgeräts weitergeführte Stromkreis mittels des jeweiligen Schaltungsausgang nicht mehr geschaltet bzw. kann über den Schaltungsausgang kein Signal mehr ausgegeben werden. Nicht zuletzt in sicherheitsgerichteten Anwendungen kann ein solcher Totalausfall des Schaltausgangs zu fatalen Folgen für die betroffene Anlage bzw. deren Umgebung führen und ist daher möglichst zeitnah zu erkennen bzw. zu beheben.

Dem Rechnung tragend besteht eine Aufgabe der Erfindung darin, Spulenanordnungen der vorbezeichneten Art bzw. damit gebildete Schaltungsausgänge, dahingehend zu verbessern, daß damit ein selbststätiges Überwachen auf Funktionstüchtigkeit ermöglicht ist, derart, daß auch durch die Spulenanordnung selbst ein Versagen des damit jeweils gebildeten elektro-mechanischen Schalters bzw. Schaltungsausgangs zeitnah erkannt werden kann; dies möglichst auch ohne Verwendung zusätzlicher externer, beispielsweise extern des Meßgeräts in den Laststromkreis einzugliedernder, Prüfmittel bzw. möglichst ohne von extern an die Spulenanordnung zusätzlich zu übermittelnde Information betreffend einen aktuellen Stromfluß oder Spannungsverlauf im Laststromkreis.

Das Dokument US 5 668 693 A offenbart eine Spulenanordnung gemäß dem Oberbegriff des Anspruchs 1.

Zur Lösung der Aufgabe besteht die Erfindung in einer Spulenanordnung, umfassend:
- eine elektrische Spule mit einem Spulenkern , beispielsweise aus einem weichmagnetischen Material und/oder einem Ferrit, und mit einem nämlichen Spulenkern umgebenden, beispielsweise nämlich mittels eines auf den Spulenkern gewickelten Spulendraht gebildeten und/oder mittels einer spiralförmigen Leiterbahn auf einer den Spulenkern fassenden Leiterkarte gebildeten, Stromleiter, beispielsweise aus Kupfer oder einer Kupferlegierung;
- einen zwischen einer ersten Endlage und einer zweiten Endlage bewegbaren, beispielsweise dauermagnetischen, Anker, beispielsweise aus einem eine Permeabilitätszahl, µᵣ, von mehr als 10 (µᵣ > 10) aufweisenden Material und/oder einem Metall;
- einen, beispielsweise elektrisch gesteuert, zwischen wenigstens zwei Schaltzuständen umschaltbaren, insb. mittels wenigstens eines Transistors gebildeten, elektronischen Schalter;
- eine, beispielsweise mittels eines Mikroprozessors gebildete, Steuer- und Überwachungsschaltung zum Erzeugen eines den elektronischen Schalter betätigenden, beispielsweise binären und/oder elektrischen, Schaltsignals mit einem veränderlichen Signalpegel;
- sowie eine Betriebsschaltung zum Bereitstellen einer, beispielsweise unipolaren, Betriebsspannung,
- wobei mittels des Spulenkerns und mittels des Ankers ein Magnetkreis gebildet ist, derart, daß nämlicher Magnetkreis einen von einer Lage des Ankers abhängigen magnetischen Widerstand, Rₘ, aufweist bzw. daß die Spule eine von der Lage des Ankers abhängige Induktivität, L, aufweist;
- wobei die Spule dafür eingerichtet ist, im Stromleiter einen elektrischen Strom zu führen und nämlichen Strom in eine zwischen deren Spulenkern und dem Anker wirkende, gleichwohl von einer Stromstärke des Stroms abhängige Magnetkraft zu wandeln;
- wobei der elektronische Schalter dafür eingerichtet ist, in einem ersten Schaltzustand einen mittels der Betriebsschaltung, der Spule sowie dem elektronische Schalter gebildeten Spulen-Stromkreis zu schließen, derart, daß ein einem dann von der Betriebsspannung getriebenen, in nämlichem Spulen-Stromkreis fließenden elektrischen Strom entgegenwirkender elektrischer Widerstand, R, des Spulen-Stromkreises dann einen, beispielsweise weniger als 100 Ω (Ohm) betragenden, ersten Widerstandswert aufweist, und in einem zweiten Schaltzustand nämlichen Spulen-Stromkreis zu öffnen, derart, daß dessen elektrischer Widerstand dann einen, beispielsweise mehr als 10 kΩ (Kiloohm) betragenden, zweiten Widerstandswert, der, beispielsweise um mehr als ein 10-faches des ersten Widerstandswerts, größer als der erste Widerstandswert ist, aufweist;
- wobei die Betriebsschaltung dafür eingerichtet ist, ein einen zeitlichen Verlauf des im Spulen-Stromkreis fließenden elektrischen Stroms repräsentierendes Strommeßsignal, beispielsweise mit einer nämlichem Strom proportionalen Spannung oder inform eines Digitalsignals, bereitzustellen;
- wobei die Steuer- und Überwachungsschaltung dafür eingerichtet ist, das Schaltsignal zeitweise mit einem den ersten Schaltzustand des elektronischen Schalters veranlassenden ersten Signalpegelwert ("H") bereitzustellen,
- wobei die Steuer- und Überwachungsschaltung dafür eingerichtet ist, das Schaltsignal zeitweise mit einem den zweiten Schaltzustand des elektronischen Schalters veranlassenden, vom ersten Signalpegelwert verschiedenen zweiten Signalpegelwert ("L") bereitzustellen;
   ▪ und wobei die Steuer- und Überwachungsschaltung dafür eingerichtet ist, unter Verwendung des, beispielsweise digitalisierten, Strommeßsignals eine Überprüfung der Spule durchzuführen, nämlich festzustellen, ob die Induktivität, L, der Spule eine Abhängigkeit von einem zeitlichen Verlauf des Schaltsignals bzw. einen mit dem zeitlichen Verlauf des Schaltsignals korrespondierenden zeitlichen Verlauf aufweist, und/oder festzustellen, ob die Spule auf eine Änderung des Signalpegels des Schaltsignals vom ersten Signalpegel ("H") auf den zweiten Signalpegel ("L") mit einer Änderung, beispielsweise nämlich mit einer Erhöhung, von deren Induktivität, L, reagiert, und/oder festzustellen, ob die Spule auf eine Änderung des Signalpegels des Schaltsignals vom zweiten Signalpegel ("L") auf den ersten Signalpegel ("H") mit einer Änderung, beispielsweise nämlich mit einer Verringerung, von deren Induktivität, L, reagiert.

Ferner besteht die Erfindung in einem elektro-mechanischer Schalter , umfassend: einen zwischen einer ersten Schaltstellung und einer zweiten Schaltstellung bewegbaren, beispielsweise federelastischen, ersten Schaltkontakt, einen zweiten Schaltkontakt und zum Betätigen des ersten Schaltkontakts eine solche Spulenanordnung, wobei deren Anker dafür eingerichtet ist, bei einem Wechsel aus dessen erster Endlage in dessen zweite Endlage den ersten Schaltkontakt aus dessen erster Schaltstellung in dessen zweite Schaltstellung zu bewegen.

Desweiteren besteht die Erfindung in einem Meßumformer, umfassend: einen solchen elektro-mechanischen Schalter; sowie eine, insb. mittels eines Mikroprozessors gebildete und/oder von der Betriebsschaltung gespeiste, Meßschaltung zum Empfangen wenigstens eines von einer physikalischen oder chemischen Meßgröße abhängigen und/oder einen zeitlichen Verlauf nämlicher Meßgröße repräsentierenden, beispielsweise elektrischen, Aufnehmersignals.

Darüberhinaus besteht die Erfindung in einem Meßgerät, umfassend: einen solchen Meßumformer; sowie einen mit der Meßschaltung nämlichen Meßumformers elektrisch gekoppelten Meßaufnehmer zum Erfassen einer, insb. lediglich innerhalb eines vorgegebenen Meßbereichs, zeitlich veränderlichen physikalischen und/oder chemischen Meßgröße und zum Generieren des wenigstens einen Aufnehmersignals.

Nach einer ersten Ausgestaltung der Spulenanordnung ist vorgesehen, daß der von der Lage des Ankers abhängige magnetische Widerstand, Rₘ, des mittels des Spulenkerns und mittels des Ankers gebildeten Magnetkreises bei in erster Endlage befindlichem Anker kleiner ist als bei in zweiter Endlage befindlichem Anker.

Nach einer zweiten Ausgestaltung der Spulenanordnung ist vorgesehen, daß die von der Lage des Ankers abhängige Induktivität, L, der Spule bei in erster Endlage befindlichem Anker größer ist als bei in zweiter Endlage befindlichem Anker.

Nach einer dritten Ausgestaltung der Spulenanordnung ist vorgesehen, daß die Steuer- und Überwachungsschaltung dafür eingerichtet ist, unter Verwendung des Strommeßsignals einen Defekt der Spule bzw. der Spulenanordnung, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, zu detektieren.

Nach einer vierten Ausgestaltung der Spulenanordnung ist vorgesehen, daß die die Steuer- und Überwachungsschaltung dafür eingerichtet ist, die Überprüfung der Spule unter Verwendung eines digitalisierten Strommeßsignals, nämlich eines den zeitlichen Verlauf des im Spulen-Stromkreis fließenden elektrischen Stroms repräsentierenden Digitalsignals durchzuführen.

Nach einer fünften Ausgestaltung der Spulenanordnung weist die Steuer- und Überwachungsschaltung einen Mikroprozessor auf. Diese Ausgestaltung der Erfindung weiterbildend ist die Steuer- und Überwachungsschaltung ferner dafür eingerichtet, mittels des Mikroprozessors die Überprüfung der Spule durchzuführen und/oder das Schaltsignal zu generieren und/oder das Strommeßsignal zu verarbeiten.

Nach einer sechsten Ausgestaltung der Spulenanordnung weist die Steuer- und Überwachungsschaltung einen flüchtigen Datenspeicher auf und ist die Steuer- und Überwachungsschaltung dafür eingerichtet, das Strommeßsignal zumindest auszugsweise in nämlichen Datenspeicher abzuspeichern, derart, daß im Datenspeicher zumindest vorübergehend zumindest eine Sequenz von digitalen Stromwerten, nämlich Digitalwerten eines digitalisierten Strommeßsignals, vorgehalten ist. Diese Ausgestaltung der Erfindung weiterbildend ist die Steuer- und Überwachungsschaltung ferner dafür eingerichtet, das Strommeßsignal in nämlichen Datenspeicher so abzuspeichern, daß zumindest vorübergehend eine einen Ausschaltvorgang der Spule, nämlich den zeitlichen Verlauf des in der Spule fließenden Stromes nach einem Wechsel des elektronischen Schalters vom ersten Schaltzustand in den zweiten Schaltzustand repräsentierende Sequenz von digitalen Stromwerten (Ausschaltstromkurve) im Datenspeicher abgespeichert ist und/oder daß zumindest vorübergehend eine einen Einschaltvorgang der Spule, nämlich den zeitlichen Verlauf des in der Spule fließenden Stromes nach einem Wechsel des elektronischen Schalters vom zweiten Schaltzustand in den ersten Schaltzustand repräsentierende Sequenz von digitalen Stromwerten (Einschaltstromkurve) im Datenspeicher abgespeichert ist.

Nach einer siebenten Ausgestaltung der Spulenanordnung ist vorgesehen, daß die Steuer- und Überwachungsschaltung dafür eingerichtet ist, anhand des Strommeßsignals, beispielsweise auch wiederkehrend, einen Stromdynamik-Kennwert, nämlich einen Kennzahlenwert für eine den zeitlichen Verlauf des in der Spule fließenden Stromes, z.B. nach einem Wechsel des elektronischen Schalters vom ersten Schaltzustand in den zweiten Schaltzustand oder nach einem Wechsel des elektronischen Schalters vom zweiten Schaltzustand in den ersten Schaltzustand, charakterisierende Kenngröße zu ermitteln, beispielsweise nämlich zu berechnen. Diese Ausgestaltung der Erfindung weiterbildend ist vorgesehen, als charakterisierende Kenngröße eine Änderungsrate des Stromes zu verwenden. Alternativ oder in Ergänzung kann beispielsweise aber auch eine ausgehend von einem Startzeitpunkt bis zum Erreichen eines vorgegebenen Stromwerts erforderliche Zeitspanne als charakterisierende Kenngröße dienen.

Nach einer achten Ausgestaltung der Spulenanordnung weist die Steuer- und Überwachungsschaltung einen flüchtigen Datenspeicher auf und ist die Steuer- und Überwachungsschaltung dafür eingerichtet, das Strommeßsignal zumindest auszugsweise in nämlichen Datenspeicher abzuspeichern, derart, daß im Datenspeicher zumindest vorübergehend zumindest eine Sequenz von digitalen Stromwerten, nämlich Digitalwerten eines digitalisierten Strommeßsignals, vorgehalten ist; darüberhinaus ist vorgesehen, daß die Steuer- und Überwachungsschaltung dafür eingerichtet ist, anhand des Strommeßsignals, beispielsweise auch wiederkehrend, unter Verwendung von im flüchtigen Datenspeicher vorgehaltenen digitalen Stromwerten einen Stromdynamik-Kennwert zu ermitteln. Diese Ausgestaltung der Erfindung weiterbildend ist die die Steuer- und Überwachungsschaltung ferner dafür eingerichtet, den Stromdynamik-Kennwert unter Verwendung einer im flüchtigen Datenspeicher zumindest vorübergehend vorgehaltenen einen Ausschaltvorgang der Spule repräsentierenden Sequenz von digitalen Stromwerten (Ausschaltstromkurve) und/oder unter Verwendung einer im flüchtigen Datenspeicher zumindest vorübergehend vorgehaltenen einen Einschaltvorgang der Spule repräsentierende Sequenz von digitalen Stromwerten (Einschaltstromkurve) zu ermitteln; beispielsweise durch Aufsummieren einer vorgegebenen Anzahl von digitalen Stromwerten, beginnend mit einem einen zu einem vorgegebenen und/oder im Betrieb ermittelten Startzeitpunkt im Spulen-Stromkreis fließenden Strom repräsentierendenden Anfangsstromwert bzw. durch Integrieren eines einen zeitlichen Verlauf des Stromes innerhalb eines vorgegebenen Zeitintervalls repräsentierenden Teilabschnitts des Strommeßsignals zu ermitteln. Alternativ oder in Ergänzung kann die Steuer- und Überwachungsschaltung ferner dafür eingerichtet sein, zur Überprüfung der Spule eine Abweichung zwischen dem Stromdynamik-Kennwert mit einem dafür vorgegebenen, beispielsweise nämlich vorab gemessenen und/oder in der Überwachungsschaltung abgespeicherten Referenzwert zu ermitteln. Zur Überprüfung der Spule kann nämliche Abweichung mittels der Steuer- und Überwachungsschaltung mit einem dafür vorgegebenen, beispielsweise vorab in der Steuer- und Überwachungsschaltung abgespeicherten und/oder eine Intervallgrenze für einen mit einer defekten Spule korrespondierenden Wertebereich der den zeitlichen Verlauf des in der Spule fließenden Stromes charakterisierende Kenngröße repräsentierenden, Schwellenwert verglichen werden. Der Schwellenwert kann beispielsweise in einem nicht-flüchtigen Datenspeicher abgespeichert sein.

Nach einer neunten Ausgestaltung der Spulenanordnung ist vorgesehen, daß die Steuer- und Überwachungsschaltung einen nicht-flüchtigen Datenspeicher aufweist.

Nach einer zehnten Ausgestaltung der Spulenanordnung ist vorgesehen, daß die Steuer- und Überwachungsschaltung dafür eingerichtet ist, ein Ergebnis der Überprüfung der Spule, beispielsweise inform eines binären oder digitalen Statussignals, auszugeben.

Nach einer elften Ausgestaltung der Spulenanordnung ist vorgesehen, daß die Steuer- und Überwachungsschaltung dafür eingerichtet ist, im Ergebnis der Überprüfung der Spule eine eine, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, defekte Spule signalisierende Nachricht zu generieren, falls eine mit einer defekten Spule korrespondierende Überschreitung eines vorgegebenen, beispielsweise nämlich vorab in der Steuer- und Überwachungsschaltung abgespeicherten und/oder eine Intervallgrenze für einen mit einer defekten Spule korrespondierenden Wertebereich repräsentierenden, Schwellenwerts ermittelt ist.

Nach einer zwölften Ausgestaltung der Spulenanordnung ist vorgesehen, daß die Steuer- und Überwachungsschaltung dafür eingerichtet ist, ein von einem Ergebnis der Überprüfung der Spule abhängiges bzw. nämliches Ergebnis vermeldendes, beispielsweise binäres oder digitales, Statussignal bereitzustellen.

Nach einer dreizehnten Ausgestaltung der Spulenanordnung ist vorgesehen, daß die Steuer- und Überwachungsschaltung einen Analog-zu-Digital-Wandler aufweist, der dafür eingerichtet ist, das Strommeßsignal zu empfangen und zu digitalisieren.

Nach einer vierzehnten Ausgestaltung der Spulenanordnung ist vorgesehen, daß die Betriebsschaltung dafür eingerichtet, das Strommeßsignal digitalisiert, nämlich inform eines den zeitlichen Verlauf des im Spulen-Stromkreis fließenden elektrischen Stroms repräsentierenden Digitalsignals auszugeben.

Nach einer fünfzehnten Ausgestaltung der Spulenanordnung weist die Betriebsschaltung ferner einen, beispielsweise in Spulen-Stromkreis eingegliederten bzw. zur Spule elektrisch in Reihe geschalteten, Meßwiderstand zum Bereitstellen einer zu dem im Spulen-Stromkreis fließenden elektrischen Strom proportionalen Meßspannung auf. Diese Ausgestaltung der Erfindung weiterbildend weist die Betriebsschaltung einen Analog-zu-Digitalwandler zum Digitalisieren der mittels des Meßwiderstands bereitgestellten Meßspannung auf bzw. ist die die Betriebsschaltung dafür eingerichtet, eine digitalisierte Meßspannung als Strommeßsignal auszugeben.

Nach einer sechzehnten Ausgestaltung der Spulenanordnung weist die Betriebsschaltung ferner einen, beispielsweise in Spulen-Stromkreis eingegliederten bzw. zur Spule elektrisch in Reihe geschalteten, Meßwiderstand zum Bereitstellen einer zu dem im Spulen-Stromkreis fließenden elektrischen Strom proportionalen Meßspannung auf und ist die die Betriebsschaltung dafür eingerichtet, das Strommeßsignals mittels der Meßspannung zu generieren und/oder die Meßspannung als, beispielsweise auch digitalisiertes, Strommeßsignal auszugeben.

Nach einer Weiterbildung der Spulenanordnung umfaßt diese weiters eine mit dem Anker mechanisch gekoppelte Rückstellfeder, die dafür eingerichtet ist, eine der Magnetkraft entgegenwirkende Rückstellkraft in den Anker einzuleiten.

Nach einer Ausgestaltung des Schalters ist vorgesehen, daß der erste Schaltkontakt dafür eingerichtet ist, in erster Schaltstellung vom zweiten Schaltkontakt unter Bildung einer hochohmigen bzw. elektrisch isolierenden Luftstrecke beabstandet zu sein, und daß der erste Schaltkontakt dafür eingerichtet ist, in zweiter Schaltstellung den zweiten Schaltkontakt unter Bildung einer niederohmigen bzw. elektrisch leitfähigen Verbindung zu berühren. Diese Ausgestaltung der Erfindung weiterbildend ist ferner vorgesehen, daß die Steuer- und Überwachungsschaltung dafür eingerichtet ist, eine ein Versagen des elektro-mechanischen Schalters, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, signalisierende Warnmeldung zu generieren, falls im Ergebnis der unter Verwendung des Strommeßsignals durchgeführten Überprüfung der Spule ein Defekt nämlicher Spule festgestellt ist.

Nach einer ersten Ausgestaltung des Meßumformers ist vorgesehen, daß die Meßschaltung dafür eingerichtet ist, ein die Steuer- und Überwachungsschaltung instruierendes, insb. nämlich eine Änderung des Signalpegels des Schaltsignals vom ersten Signalpegel auf den zweiten Signalpegel oder eine Änderung des Signalpegels des Schaltsignals vom ersten Signalpegel auf den zweiten Signalpegel veranlassendes und/oder ein digitales, Steuersignal zu generieren. Diese Ausgestaltung der Erfindung weiterbildend ist die Meßschaltung ferner dafür eingerichtet, das Steuersignal unter Verwendung des Aufnehmersignals und/oder in Abhängigkeit zumindest eines der Meßwerte zu generieren.

Nach einer zweiten Ausgestaltung des Meßumformers ist vorgesehen, daß die Meßschaltung dafür eingerichtet ist, unter Verwendung nämlichen Aufnehmersignals Meßwerte für die Meßgröße zu ermitteln.

Nach einer dritten Ausgestaltung des Meßumformers ist mittels des elektro-mechanischen Schalters ein Schaltausgang des Meßumformers gebildet. Diese Ausgestaltung der Erfindung weiterbildend ist der Schaltsausgang dafür eingerichtet ist, einen teilweise extern des Meßumformers verlaufenden Stromkreis zu schalten.

Nach einer ersten Weiterbildung des Meßumformer umfaßt dieser weiters: ein Umformer-Gehäuse, wobei sowohl die Meßschaltung als auch der elektro-mechanische Schalter innerhalb des Umformer-Gehäuses plaziert sind.

Nach einer zweiten Weiterbildung des Meßumformer umfaßt dieser weiters: ein von der Steuer- und Überwachungsschaltung angesteuertes, beispielsweise innerhalb eines Umformer-Gehäuses des Meßumformers plaziertes und/oder dem Anzeigen eines Ergebnisses der Überprüfung der Spule dienendes, Anzeigeelement. Hierbei kann die Steuer- und Überwachungsschaltung zudem dafür eingerichtet sein, ein Ergebnis der Überprüfung der Spule, beispielsweise inform eines binären oder digitalen Statussignals, an das Anzeigeelement zu übermitteln bzw. kann das Anzeigeelement dafür eingerichtet sein, nämliches Ergebnis der Überprüfung der Spule visuell wahrnehmbar anzuzeigen.

Ein Grundgedanke der Erfindung besteht darin, eine für eine Spulenanordnungen der in Rede stehenden Art typische Abhängigkeit deren jeweilige magnetischen Widerstands bzw. deren jeweiliger Induktivität von einer momentanen Lage des betriebsgemäß bewegbaren, nämlich mittels der Spule betätigten Ankers dafür zu nutzen, eine Funktionstüchtigkeit der Spulenanordnung im Betrieb zu überprüfen, derart, daß bei Ausbleiben eines für die jeweilige Spule spezifischen Änderns des magnetischen Widerstands bzw. der Induktivität nach dem Ein- bzw. Ausschalten des mittels der jeweiligen Spule gebildeten Spulen-Stromkreises auf einen fehlerhaften Anker geschlossen wird, mithin eine defekte Spule bzw. eine defekte Spulenanordnung detektiert wird.

Die Erfindung sowie weitere vorteilhafte Ausgestaltungen davon werden nachfolgend anhand von Ausführungsbeispielen näher erläutert, die in den Figuren der Zeichnung dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung wie auch den Unteransprüchen an sich. Im einzelnen zeigen:
- Fig. 1: schematisch eine, insb. zur Realisierung eines Schalt- oder Relaisausgang eines Meßgerät der industriellen Meß- und Automatisierungstechnik geeignete, Spulenanordnung;
- Fig. 2a, b, c: eine Zusammenstellung von die Wirkungsweise der in Fig. 1 gezeigten Spulenanordnung schematisch illustrierenden Zeitreihen- bzw. Kennlinien-Diagrammen;
- Fig. 3: schematisch einen mittels einer in Fig. 1 gezeigten Spulenanordnung gebildeten, insb. für ein Meßgerät der industriellen Meß- und Automatisierunsgtechnik geeigneten, *elektro-mechanischen Schalter*, und
- Fig. 4: schematisch einen Meßumformer mit einem elektro-mechanischen Schalter bzw. ein damit gebildetes Meßgerät.

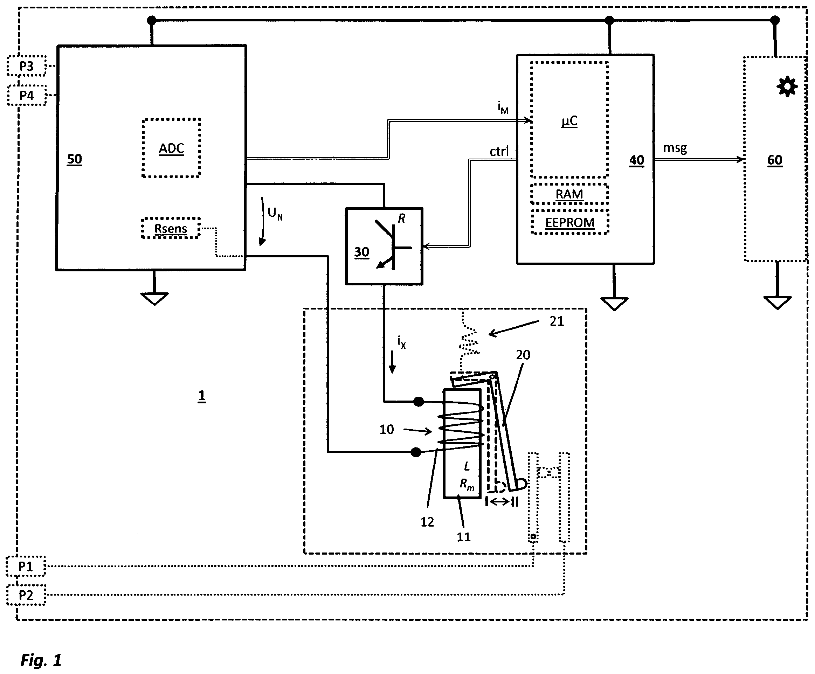

In der Fig. 1 ist schematisch nach Art eines Blockschaltbildes ein Ausführungsbeispiel für eine, insb. zur Herstellung eines für die Verwendung in einem Meßgerät der industriellen Meß- und Automatisierungstechnik geeigneten elektro-mechanischen Schalters dienlichen, Spulenanordnung dargestellt.

Die Spulenanordnung weist eine elektrische Spule 10 mit einem Spulenkern 11, beispielsweise aus einem weichmagnetischen Material und/oder einem Ferrit, und mit einem nämlichen Spulenkern umgebenden, beispielsweise nämlich mittels eines auf den Spulenkern gewickelten Spulendraht gebildeten und/oder mittels einer spiralförmigen Leiterbahn auf einer den Spulenkern fassenden Leiterkarte gebildeten, Stromleiter 12, z.B. aus Kupfer oder einer Kupferlegierung, sowie - benachbart zur Spule - einen zwischen einer ersten Endlage I und einer zweiten Endlage II bewegbaren, beispielsweise dauermagnetischen und/oder abgewinkelten und/oder schwenkbaren, Anker 20 auf. Mittels des Spulenkerns 11 und mittels des - beispielsweise als Klappanker ausgebildeten - Ankers 20 ist ein Magnetkreis gebildet, der eine von einer Lage des Ankers abhängigen magnetischen Widerstand Rₘ aufweist, so daß die Spule eine von der Lage des Ankers abhängige Induktivität L aufweist. Der Anker kann beispielsweise aus einem eine Permeabilitätszahl µᵣ von mehr als 10 (µᵣ > 10) aufweisenden Material und/oder einem Metall bestehen. Im hier gezeigten Ausführungsbeispiel sind der Spulenkern und der Anker ferner so ausgebildet und positioniert, daß nämlicher magnetischer Widerstand Rₘ des Magnetkreises bei in erster Endlage I befindlichem Anker 20 kleiner ist als bei in zweiter Endlage befindlichem Anker 20 bzw. daß nämliche Induktivität L der Spule 10 bei in erster Endlage I befindlichem Anker 20 größer ist als bei in zweiter Endlage befindlichem Anker 20.

Die Spule ist unter Zwischenschaltung eines elektronischen, nämlich mittels wenigstens eines Halbleiterelements, beispielsweise einem Transistor, gebildeten Schalter 30 der Spulenanordnung an eine eine, beispielsweise als eine weniger als 30 V (Volt) betragende Gleichspannung ausgebildete und/oder unipolare, Betriebsspannung bereitstellende Betriebsschaltung 50 der Spulenanordnung zwecks Bildung eines Spulen-Stromkreises elektrisch angeschlossen und zudem dafür eingerichtet, im Stromleiter zumindest zeitweise einen elektrischen Strom iₓ zu führen und nämlichen Strom in eine zwischen deren Spulenkern und dem Anker wirkende, gleichwohl von einer Stromstärke des Stroms iₓ abhängige Magnetkraft zu wandeln. Nämliche Magnetkraft dient gemäß einer Ausgestaltung der Erfindung insbesondere dazu, den Anker 20 in dessen zweite Endlage II zu bewegen bzw. dort verharren zu lassen. Um den Anker 20 gelegentlich von dessen zweiter Endlage II wieder zurück in dessen erste Endlage I zu bewegen bzw. daselbst auch verharren zu lassen umfaßt die Spulenanorndung nach einer weiteren Ausgestaltung der Erfindung eine mit dem Anker 20 mechanisch gekoppelte Rückstellfeder 21, die dafür eingerichtet ist, eine der - hier nämlich den Anker in dessen zweite Endlage verbringenden bzw. dort haltenden - Magnetkraft entgegenwirkende Rückstellkraft in den Anker einzuleiten, derart, daß die Rückstellfeder durch verbringen des Ankers in dessen zweite Endlage II gespannt wird bzw. nach einer Verringerung der Magnetkraft unterhalb eines konstruktionsbedingten Mindestkraftwerts oder eines Verschwindens derselben wieder entspannt, einhergehend mit einer Bewegung des Ankers zurück in dessen erste Endlage I.

Der elektronische Schalter 30 wiederum ist dafür, insb. elektrisch gesteuert, zwischen wenigstens zwei Schaltzuständen umschaltbar und im besonderen dafür eingerichtet, in einem ersten Schaltzustand den mittels der Betriebsschaltung, der Spule sowie dem elektronische Schalter gebildeten Spulen-Stromkreis zu schließen und in einem zweiten Schaltzustand nämlichen Spulen-Stromkreis zu öffnen; dies im besonderen in der Weise, daß ein einem von der Betriebsspannung getriebenen, in nämlichem Spulen-Stromkreis fließenden elektrischen Strom iₓ entgegenwirkender elektrischer Widerstand des Spulen-Stromkreises bei im ersten Schaltzustand befindlichem Schalter 30 einen, beispielsweise weniger als 100 Ω (Ohm) betragenden, ersten Widerstandswert und bei im zweiten Schaltzustand befindlichem Schalter 30 einen, beispielsweise mehr als 10 kΩ (Kiloohm) betragenden, zweiten Widerstandswert aufweist, der, beispielsweise um mehr als ein 10-faches des ersten Widerstandswerts, größer als der erste Widerstandswert ist. Die Änderungen des elektrischer Widerstands in der vorbeschriebenen Weise wiederum führt zu einer entsprechenden Änderung Stromstärke des Strom iₓ, derart, daß - bei jeweils gleicher Betriebsspannung - der Strom iₓ bei in erstem Schaltzustand befindlichem Schalter 30 eine höhere Stromstärke aufweist, als bei in zweiten Schaltzustand befindlichem Schalter 30.

Zwecks des Betätigens des elektronischen Schalters 30 bzw. eines kontrollierten Einstellens nämlicher Stromstärke des in der Spule fließenden Stroms iₓ weist die Spulenanordnung ferner eine, beispielsweise mittels eines Mikroprozessors gebildete, Steuer- und Überwachungsschaltung 40 auf, die dafür eingerichtet ist ein den elektronischen Schalter 30 betätigendes, beispielsweise binäres und/oder elektrisches, Schaltsignal ctrl mit einem veränderlichen Signalpegel bereitzustellen bzw. zu erzeugen, derart, daß das Schaltsignal ctrl zeitweise einen den ersten Schaltzustand des elektronischen Schalters veranlassenden ersten Signalpegelwert ("H") und zeitweise einen den zweiten Schaltzustand des elektronischen Schalters veranlassenden, vom ersten Signalpegelwert verschiedenen zweiten Signalpegelwert ("L") aufweist. Nach einer Ausgestaltung der Erfindung weist die Steuer- und Überwachungsschaltung 40 einen Mikroprozessor µC auf. Ferner ist die Steuer- und Überwachungsschaltung dafür eingerichtet, das Schaltsignal ctrl mittels nämlichen Mikroprozessors µC zu generieren.

Um möglichst zeitnah einen allfälligen die Funktionstüchtigkeit der Spulenanordnung beeinträchtigenden Defekt der Spule 10 bzw. einen damit einhergehenden Ausfall der Spulenanordnung insgesamt detektieren zu können, ist die Steuer- und Überwachungsschaltung 40 der erfindungsgemäßen Spulenanordnung ferner dafür vorgesehen, im Betrieb, beispielsweise automatisch und/oder auf Anfrage, unter Auswertung eines zeitlichen Verlaufs des im Spulen-Stromkreis fließenden elektrischen Stroms eine Überprüfung der Spule 10 durchzuführen. Ein solcher, ggf. zu detektierender Defekt der Spule 10 kann beispielsweise darin bestehen bzw. daraus resultieren, daß der Anker 20 blockiert und/oder die ggf. vorgesehene Rückstellfeder abgebrochen ist, derart, daß im Ergebnis der Anker 20 sowohl bei den ersten Signalpegelwert aufweisendem Schaltsignal ctrl als auch bei den zweiten Signalpegelwert aufweisendem Schaltsignal ctrl in erster Endlage I verharrt oder sowohl bei den ersten Signalpegelwert aufweisendem Schaltsignal ctrl als auch bei den zweiten Signalpegelwert aufweisendem Schaltsignal ctrl in zweiter Endlage II verharrt. Eine weiterer Defekt kann beispielsweise auch darin bestehen, daß der Anker abgebrochen oder auch vollständig entfernt ist. Im besonderen ist die die Steuer- und Überwachungsschaltung 40 ferner dafür eingerichtet, die Überprüfung der Spule 10 unter Verwendung eines digitalisierten Strommeßsignals, nämlich eines den zeitlichen Verlauf des im Spulen-Stromkreis fließenden elektrischen Stroms repräsentierenden Digitalsignals durchzuführen. Dementsprechend ist die Betriebsschaltung 50 ferner eingerichtet, ein nämlichen zeitlichen Verlauf des im Spulen-Stromkreis fließenden elektrischen Stroms iₓ repräsentierendes Strommeßsignal i_{M}, beispielsweise mit einer nämlichem Strom proportionalen Spannung oder inform eines Digitalsignals, bereitzustellen, und ist die Steuer- und Überwachungsschaltung 50 ferner eingerichtet, unter Verwendung des, ggf. zunächst digitalisierten, Strommeßsignals i_{M} eine Überprüfung der Spule durchzuführen, beispielsweise auch mittels des ggf. vorgesehenen Mikroprozessors und/oder im Zusammenhang mit einer automatisierten Selbstdiagnose der Spulenanordnung. Ein durch die Steuer- und Überwachungsschaltung allfällig detektierter Defekt der Spule bzw. der damit gebildeten Spulenanordnung kann ferner auch nach außerhalb vermeldet werden, beispielsweise durch Ausgeben einer entsprechenden Warnmeldung über ein an die Steuer- und Überwachungsschaltung 40 angeschlossenes Anzeigeelement, wie z.B. ein Flüssigkristallanzeige (LCD) oder eine Leuchtdiode (LED), und/oder durch Ausgeben eines nämlichen Defekt anzeigenden Statussignals an einer, ggf. auch als Service-Schnittstelle ausgebildeten Signalausgang.

Zwecks Generierung des Strommeßsignals i_{M} weist die Betriebsschaltung 50 gemäß einer weiteren Ausgestaltung der Erfindung einen Meßwiderstand Rsens zum Bereitstellen einer zu dem im Spulen-Stromkreis fließenden elektrischen Strom proportionalen Meßspannung auf. Im einfachsten Fall kann der Meßwiderstand Rsens - wie auch in Fig. 1 angedeutet - unmittelbar in Spulen-Stromkreis eingegliederten bzw. zur Spule L elektrisch in Reihe geschaltet sein. Nämliche Meßspannung kann von der Betriebsschaltung - direkt verwendet oder unter Verwendung einer zusätzlichen Verstärkerschaltung - beispielsweise als analoges, ggf. auch zwischenverstärktes Strommeßsignal ausgegebenen werden. Nicht zuletzt für den vorbeschriebenen Fall, daß die Steuer- und Überwachungsschaltung 50 dafür eingerichtet ist, ein digitalisiertes Strommeßsignal i_{M} zu verarbeiten bzw. auszuwerten, kann die Betriebsschaltung ferner zudem auch einen Analog-zu-Digitalwandler zum Digitalisieren der mittels des Meßwiderstands bereitgestellten Meßspannung aufweisen und zudem dafür eingerichtet sein, eine entsprechend digitalisierte Meßspannung als - in dem Fall digitalisiertes - Strommeßsignal bereitzustellen.

Bei der erfindungsgemäßen Spulenanordnung erfolgt die Überprüfung der Spule 10 durch die Steuer- und Überwachungsschaltung 40, indem diese anhand des Strommeßsignals i_{M} feststellt, ob die Induktivität L der Spule eine - erwartete bzw. vorbestimmte, nämlich mit einer Bewegung eines intakten Ankers von dessen einer Endlage in dessen andere korrespondierende - Abhängigkeit vom zeitlichen Verlauf des Schaltsignals ctrl bzw. einen mit dem zeitlichen Verlauf des Schaltsignals ctrl korrespondierenden zeitlichen Verlauf aufweist. Dies beispielsweise nämlich derart, daß die Steuer- und Überwachungsschaltung 40 feststellt, ob die Spule eine mit einem veränderlichen Signalpegel des Schaltsignals entsprechend korrespondierende, nämlich aus einer Bewegung des Ankers von dessen einer Endlage in die jeweils andere resultierende veränderlich Induktivität L aufzeigt. Alternativ oder in Ergänzung kann die Überprüfung der Spule 10 durch die Steuer- und Überwachungsschaltung auch dadurch erfolgen, daß die Steuer- und Überwachungsschaltung anhand des Strommeßsignals i_{M} feststellt, ob die Spule auf eine Änderung des Signalpegels des Schaltsignals vom ersten Signalpegel ("H") auf den zweiten Signalpegel ("L") mit einer Änderung von deren Induktivität L reagiert, beispielsweise nämlich mit einer Erhöhung infolge eines Bewegens des Ankers aus dessen zweiter in dessen erste Endlage, und/oder daß die Steuer- und Überwachungsschaltung anhand des Strommeßsignals i_{M} feststellt, ob die Spule auf eine Änderung des Signalpegels des Schaltsignals vom zweiten Signalpegel auf den ersten Signalpegel mit einer entsprechenden Änderung von deren Induktivität L reagiert, beispielsweise nämlich mit einer Verringerung infolge eines Bewegens des Ankers aus dessen erster in dessen zweite Endlage.

Die Steuer- und Überwachungsschaltung ist für den vorbeschriebenen Fall, daß sie einen Mikroprozessors aufweist, ferner dafür eingerichtet, das Strommeßsignal mittels nämlichen Mikroprozessors zu verarbeiten. Beispielsweise kann das Strommeßsignal als eine zum Strom proportionale Gleichspannung ausgebildet und einem analogen Signaleingang des entsprechend eingerichteten Mikroprozessors angelegt sein, um damit digitalisiert, nämlich in ein den zeitlichen Verlauf des im Spulen-Stromkreis fließenden elektrischen Stroms repräsentierendes Digitalsignal gewandelt zu werden und hernach ausgewertet zu werden. Alternativ oder in Ergänzung kann die Steuer- und Überwachungsschaltung aber auch einen separaten, mithin nicht in den ggf. vorgesehenen Mikroprozessor integrierten Analog-zu-Digital-Wandler aufweisen. Nämlicher Analog-zu-Digital-Wandler kann ebenfalls dafür eingerichtet sein, das Strommeßsignal zu empfangen und entsprechende zu digitalisieren. Ferner ist es aber auch möglich, die Betriebsschaltung so auszugestalten und einzurichten, daß diese bereits das Strommeßsignal digitalisiert, also inform eines den zeitlichen Verlauf des im Spulen-Stromkreis fließenden elektrischen Stroms repräsentierenden Digitalsignals ausgeben kann.

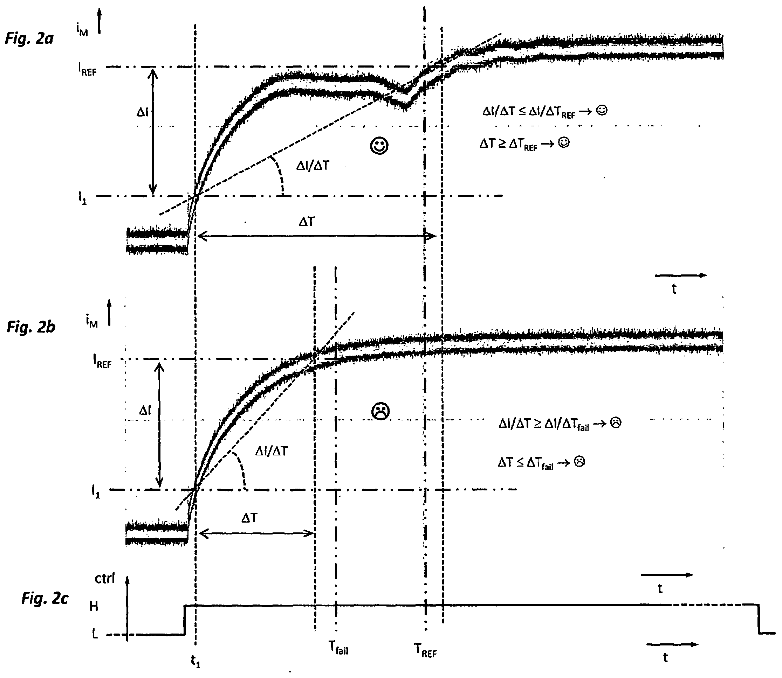

Für den vorbeschriebenen Fall, daß das Strommeßsignal inform eines Digitalsignals vorliegt bzw. von der Steuer- und Überwachungsschaltung in digitalisierter Form zu verarbeiten ist, weist die Steuer- und Überwachungsschaltung nach einer weiteren Ausgestaltung der Erfindung einen flüchtigen Datenspeicher RAM auf. Ferner ist die Steuer- und Überwachungsschaltung hierbei dafür eingerichtet, das (digitalisierte) Strommeßsignal zumindest auszugsweise in nämlichen Datenspeicher RAM abzuspeichern, derart, daß im Datenspeicher RAM zumindest vorübergehend zumindest eine Sequenz von digitalen Stromwerten, nämlich Digitalwerten eines digitalisierten Strommeßsignals, vorgehalten ist und somit für eine weitere Auswertung durch die Steuer- und Überwachungsschaltung zumindest für eine vorgegebene Zeitdauer vorgehaltenen ist. Ferner ist die Steuer- und Überwachungsschaltung bzw. deren ggf. vorgesehener Mikroprozessor dafür eingerichtet, die Überprüfung der Spule unter Verwendung nämlicher Sequenz von digitalen Stromwerten durchzuführen. Beispielsweise kann die im Datenspeicher vorgehaltene Sequenz so gewählt sein, daß sie einen Ausschaltvorgang der Spule, nämlich den zeitlichen Verlauf des in der Spule fließenden Stromes nach einem Wechsel des elektronischen Schalters vom ersten Schaltzustand in den zweiten Schaltzustand repräsentierende, gelegentlich auch als Ausschaltstromkurve bezeichnete Sequenz von digitalen Stromwerten im Datenspeicher abgespeichert ist, und/oder daß zumindest vorübergehend eine einen Einschaltvorgang der Spule, nämlich den zeitlichen Verlauf des in Spule fließenden Stromes nach einem Wechsel des elektronischen Schalters vom zweiten Schaltzustand in den ersten Schaltzustand repräsentierende, gelegentlich auch als Einschaltstromkurve bezeichnete Sequenz von digitalen Stromwerten im Datenspeicher abgespeichert ist. Stellvertretend für solche zeitlichen Verläufe des in der Spule fließenden Stromes sind in der Fig. 2a bzw. 2b Beispiele für jeweils einen Einschaltvorgang der Spule repräsentierenden Sequenzen dargestellt, wobei in Fig. 2a eine mit einer intakten Spule ( 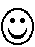 ) aufgenommene Einschaltstromkurve und in Fig. 2b eine mit einer im vorbezeichneten Sinne defekten Spule ( 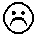 ) aufgenommene Einschaltstromkurve zeigen.

Wie durch einen Vergleich der beiden in Fig. 2a bzw. 2b gezeigten zeitlichen Verläufen des in der jeweiligen Spule jeweils fließenden Stromes mit dem in Fig. 2c gezeigeten korrespondierenden zeitlichen Verlauf des Schaltsignals ctrl ohne weiteres ersichtlich, kann sich ein zeitlicher Verlauf des Stromes einer intakten Spule von dem einer defekten Spule u.a. dadurch signifikant unterscheiden, daß der in einem Spulen-Stromkreis mit intakter Spule jeweils fließende Strom im Vergleich zu einem Strom in nämlichem Spulen-Stromkreis mit defekter Spule fließenden Strom auf Änderungen des Schaltzustand des Schalters bzw. damit einhergehende Änderung des vorbezeichneten elektrischen Widerstands des Spulen-Stromkreis stärker verzögert bzw. langsamer reagiert; dies im besonderen auch derart, daß beispielsweise bei intakter Spule der Strom nach einem (sprungförmigen) Wechsel des Schalters von dessen zweiten in dessen ersten Schaltzustand bzw. nach einem dementsprechenden Einschalten des Spulen-Stromkreises langsamer auf einen - hier praktisch einem Haltestrom entsprechenden - stationären Endwert zustrebt als bei im vorbezeichneten Sinne defekter Spule bzw. daß nämlicher Strom bei defekter Spule einen nämlichen Endwert oder einem damit korrespondierenden vorbestimmten Refernzwert I_{REF} zeitlich eher erreichen kann als bei intakter Spule und gleicher Betriebsspannung. Demnach kann also der Spulen-Stromkreis eine vom jeweiligen Zustand (bzw. Fehlerzustand) der Spule abhängige Dynamik aufweisen, die wiederum anhand von aus dem zeitlichen Verlauf des darin fließenden Strom gewonnenen Kennzahlen numerisch darstellbar ist, gleichwohl je nach Höhe eines jeweiligen Kennzahlenwerts auf eine intakte oder eine defekte Spulen schließen läßt. Dementsprechend ist die Steuer- und Überwachungsschaltung nach einer weiteren Ausgestaltung der Erfindung ferner dafür eingerichtet, anhand des Strommeßsignals i_{M}, ggf. auch wiederkehrend, einen Stromdynamik-Kennwert, nämlich einen Kennzahlenwert für eine den zeitlichen Verlauf des in der Spule bzw. dem damit gebildeten Spulen-Stromkreis fließenden Stromes iₓ, mithin eine Dynamik des Spulen-Stromkreises charakterisierende Kenngröße zu ermitteln bzw. zu berechnen. Bei nämlicher Kenngröße kann es sich beispielsweise um eine solche handeln, die einen dynamischen Übergangsbereich des Stromes, nämlich einen zeitlichen Verlauf des Stromes zeitlich unmittelbar nach einem Wechsel des elektronischen Schalters vom ersten Schaltzustand in den zweiten Schaltzustand oder nach einem Wechsel des elektronischen Schalters vom zweiten Schaltzustand in den ersten Schaltzustand charakterisiert, wie z.B. eine Änderungsrate ΔI/ΔT des Stromes iₓ oder eine ausgehend von einem entsprechenden Startzeitpunkt t₁ bis zum Erreichen eines vorgegebenen Stromwerts I_{REF} erforderliche Zeitspanne ΔT. Als Startzeitpunkt t₁ kann beispielsweise ein solcher Zeitpunkt gewählt sein, zu dem mittels der Steuer- und Überwachungschaltung anhand des Strommeßsignals festgestellt werden kann, daß der Strom iₓ nach einem Wechsel des Schalters 30 von dessen ersten in dessen zweiten Schaltzustand und/oder umgekehrt einen vorgegebenen - hier also als Triggerschwelle für eine Zeitmessung dienenden - Anfangsstromwert I₁ erreicht hat. Die zu ermittelnde Änderungsrate ΔI/ΔT des Stromes iₓ kann, wie auch in Fig. 2a bzw. 2b jeweils angedeutet, beispielsweise auch eine für die vorbezeichnete Zeitspanne ΔT im Durchschnitt herrschende Änderungsrate des Stromes sein, die bei intakter Spule ( 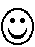 ) einer dafür vorgegebenen ersten Änderungsrate ΔI/ΔT_{REF} entspricht oder kleiner als diese ist bzw. die bei defekter Spule ( 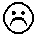 ) einer dafür vorgegebenen zweiten Änderungsrate ΔI/ΔT_{fail} entspricht oder größer als diese ist. Eine weitere Möglichkeit zur Berechnung eines solchen, nämlich zur Überprüfung der Spule 10 geeigneten Stromdynamik-Kennwerts besteht beispielsweise auch darin, einen für einen dynamischen Übergangsbereich der vorbezeichneten Art - beispielsweise also ein unmittelbar an einen Wechsel des Schalters 30 von dessen einen in dessen anderen Schaltzustand anschließendes oder auch ein andere geeignetes Zeitintervall - ermittelten, nämlich den zeitlichen Verlauf des Stromes innerhalb des jeweils entsprechend vorgegebenen Zeitintervalls repräsentierenden Teilabschnitt des Strommeßsignals i_{M} aufzuintegrieren, veranschaulicht also eine von dem nämlichem Zeitintervall entsprechenden Teilabschnitt des Strommeßsignals eingeschlossen Fläche zu ermitteln. Nämliches vorbestimmtes bzw. vorgegebenes Zeitintervall kann beispielsweise einer zwischen einem vorgegebenen Startzeitpunkt t₁ und einem vorgegebenen Endzeitpunkt T_{REF} liegende Zeitspanne ΔT_{REF} - t₁ entsprechen.

Für den vorbeschriebenen Fall, daß in der Steuer- und Überwachungsschaltung ein flüchtiger Datenspeicher RAM vorgesehen ist, kann die Steuer- und Überwachungsschaltung hierfür ferner eingerichtet sein, mit zumindest einem der vorbezeichneten dynamischen Übergangsbereiche korrespondierende digitale Stromwerte zumindest vorübergehend in nämlichem Datenspeicher RAM abzuspeichern und hernach den Stromdynamik-Kennwert unter Verwendung von im flüchtigen Datenspeicher RAM vorgehaltenen digitalen Stromwerten zu ermitteln, beispielsweise nämlich unter Verwendung einer im Datenspeicher RAM zumindest vorübergehend vorgehaltenen, einen Ausschaltvorgang der Spule, mithin eine Ausschaltstromkurve repräsentierenden Sequenz von digitalen Stromwerten und/oder unter Verwendung einer im Datenspeicher RAM zumindest vorübergehend vorgehaltenen einen Einschaltvorgang der Spule, mithin eine Einschaltstromkurve repräsentierenden Sequenz von digitalen Stromwerten, und/oder unter Verwendung einer im Datenspeicher RAM zumindest vorübergehend vorgehaltenen einen anderen geeigneten dynamischen Übergangsbereich repräsentierenden Sequenz von digitalen Stromwerten. Nach einer weiteren Ausgestaltung der Erfindung ist die Steuer- und Überwachungsschaltung hierbei ferner eingerichtet, den Stromdynamik-Kennwert durch Aufsummieren einer vorgegebenen Anzahl von digitalen Stromwerten, beginnend mit einem einen zu einem vorgegebenen und/oder im Betrieb ermittelten Startzeitpunkt t₁ im Spulen-Stromkreis fließenden Strom repräsentierendenden Anfangsstromwert I₄, beispielsweise auch um das vorbezeichnete Integrieren eines Teilabschnitt des Strommeßsignals i_{M} durchzuführen.

Der vorbeschriebene Stromdynamik-Kennwert kann im Zuge einer Überprüfung der Spule 10 bzw. der damit gebildeten Spulenanordnung hernach mit einem oder mehreren entsprechend vorbestimmten, nämlich vorab für ein bzw. mehrere verschiedene Defektszenarien ermittelten und jeweils in der Steuer- und Überwachungsschaltung hinterlegten Referenzwerten verglichen werden, beispielsweise um basierend auf einem solchen Vergleich zumindest festzustellen, ob die Spule immer noch intakt oder eben bereits defekt ist. Dementsprechend ist die Steuer- und Überwachungsschaltung nach einer weiteren Ausgestaltung der Erfindung ferner dafür eingerichtet, zwecks Überprüfung der Spule eine Abweichung zwischen dem jeweils ermittelten Stromdynamik-Kennwert mit einem dafür vorgegebenen, beispielsweise also vorab gemessenen und/oder in der Überwachungsschaltung abgespeicherten Referenzwert zu ermitteln, insb. nämlich zu berechnen. Ferner ist die Steuer- und Überwachungsschaltung nach einer weiteren Ausgestaltung der Erfindung ergänzend dafür eingerichtet, zur Überprüfung der Spule nämliche Abweichung mit einem dafür vorgegebenen, beispielsweise wiederum vorab in der Steuer- und Überwachungsschaltung abgespeicherten Schwellenwert THR zu vergleichen. Nämlicher Schwellenwert THR kann im einfachsten Fall einem für eines der vorbeschrieben Defektszenarien der Spule vorab ermittelten Referenzwert oder einer Intervallgrenze für einen mit einer defekten Spule korrespondierenden Wertebereich für eine dem jeweiligen Stromdynamik-Kennwert entsprechende *Kenngröße* repräsentieren. Der wenigstens eine, ggf. auch Schwellenwert TRH dienende Referenzwert bzw. die vorbezeichneten Referenzwerte können beispielsweise in einem in der Steuer- und Überwachungsschaltung vorgesehenen nicht-flüchtiger Datenspeicher EEPROM abgespeichert sein. Für den vorbeschriebenen Fall, daß die Steuer- und Überwachungsschaltung zudem wenigstens einen Mikroprozessor µC aufweist, kann in nämlichem Datenspeicher EEPROM weiters auch wenigstens ein, beispielsweise auch die Generierung des Schaltsignals ctrl und/oder die Überprüfung der Spule kontrollierendes Steuerungsprogramms für Mikroprozessor µC vorgehalten sein.

Nach einer weiteren Ausgestaltung der Erfindung ist die Steuer- und Überwachungsschaltung ferner dafür eingerichtet, zumindest gelegentlich, beispielsweise nämlich automatisiert bei einstweiliger Beendigung einer Überprüfung der Spule und/oder auf Abruf, ein Ergebnis der Überprüfung der Spule auszugeben, beispielsweise nämlich inform eines von einem Ergebnis der Überprüfung der Spule abhängigen bzw. das Ergebnis vermeldenden, insb. binären oder digitalen, Statussignal msg bereitzustellen. Alternativ oder in Ergänzung ist ferner vorgesehen, daß die Steuer- und Überwachungsschaltung im Ergebnis der Überprüfung der Spule eine eine defekte Spule bzw. eine defekte Spulenanordnung - beispielsweise inform eines entsprechenden Fehlercodes und/oder als Klartext - signalisierende Nachricht generiert, beispielsweise falls eine mit einer defekten Spule korrespondierende Überschreitung des vorbezeichneten Schwellenwerts TRH ermittelt ist. Nämliche Nachricht kann neben dem Vermelden des Defekts beispielsweise auch dazu dienen, eine oder mehrere möglich Ursachen für den Defekt anzugeben, beispielsweise derart, daß der Defekt darin besteht bzw. bestehen kann, daß der Anker 20 sowohl bei den ersten Signalpegelwert ("H") aufweisendem Schaltsignal ctrl als auch bei den zweiten Signalpegelwert ("L") aufweisendem Schaltsignal ctrl in erster Endlage I verharrt oder daß der Anker 20 sowohl bei den ersten Signalpegelwert ("H") aufweisendem Schaltsignal cltr als auch bei den zweiten Signalpegelwert ("L") aufweisendem Schaltsignal ctrl in zweiter Endlage II verharrt, oder etwa derart, daß der Defekt darin besteht bzw. bestehen kann, daß er Anker 20 weggebrochen, blockiert bzw. entfernt ist. Die Nachricht kann beispielsweise unverzüglich nach außen ausgegeben, beispielsweise via an die die Steuer- und Überwachungsschaltung angeschlossenes Anzeigeelement, und/oder in einen nicht-flüchtigen Datenspeicher, ggf. auch zusammen mit einem aktuellen Datum und/oder einer aktuellen Uhrzeit eingeschrieben und daselbst für eine spätere Auswertung vorgehalten werden.

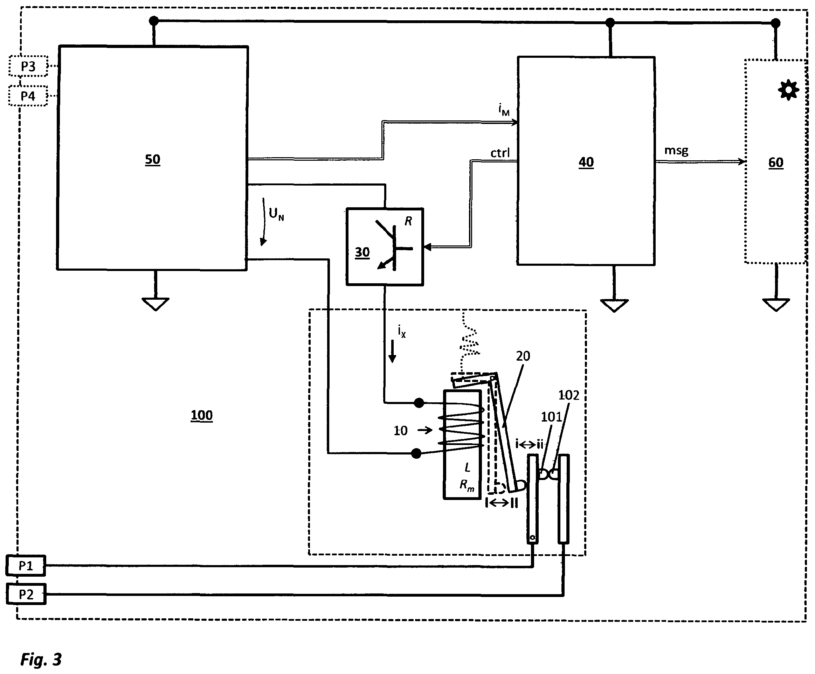

Nach einer weiteren Ausgestaltung der Erfindung ist die Spulenanordnung als ein Bestandteil eines elektro-mechanischen Schalters 100 ausgebildet, welcher Schalter 100, wie in Fig. 3 schematisch dargestellt bzw. aus einer Zusammenschau der Fig. 1 und 3 ohne weiteres ersichtlich, zusätzlich zur Spulenanordnung einen zwischen einer ersten Schaltstellung i und einer zweiten Schaltstellung ii bewegbaren, beispielsweise auch federelastischen bzw. federelastisch gelagerten, ersten Schaltkontakt 101 sowie einen - dazu antagonistischen - zweiten Schaltkontakt 102 umfaßt, bzw. ist vorgesehen nämliche Spulenanordnung zur Bildung eines elektro-mechanischen Schalters bzw. Relais zu verwenden. Die Spulenanordnung dient hierbei - wie bei solchen elektro-mechanischen Schaltern bzw. Relais üblich - im besonderen dazu, den Schaltkontakt 101 zu betätigen, wobei der Anker 20 dafür eingerichtet und plaziert ist, um bei einem Wechsel aus dessen erster Endlage I in dessen zweite Endlage II den ersten Schaltkontakt 101 mitzunehmen bzw. freizugeben, derart, daß nämlicher Schaltkontakt 101 aus dessen erster Schaltstellung i in dessen zweite Schaltstellung ii bewegt wird. Ferner ist der Anker 20 dafür eingerichtet und plaziert, um bei einem Wechsel aus dessen zweiter Endlage II in dessen erste Endlage I den ersten Schaltkontakt 101 mitzunehmen bzw. freizugeben, derart, daß nämlicher Schaltkontakt 101 aus dessen zweiter Schaltstellung ii in dessen erste Schaltstellung i bewegt wird. Der erste Schaltkontakt 101 wiederum ist gemäß einer weiteren Ausgestaltung der Erfindung dafür eingerichtet ist, in erster Schaltstellung i vom zweiten Schaltkontakt unter Bildung einer hochohmigen bzw. elektrisch isolierenden Luftstrecke beabstandet zu sein, bzw. in zweiter Schaltstellung ii den Schaltkontakt 102 unter Bildung einer niederohmigen bzw. elektrisch leitfähigen Verbindung zu berühren, beispielsweise um einen mittels der beiden Schaltkontakte 101, 102 gebildeten - hier über Anschlußklemmen P1, P2 geführten - Stromkreis zu unterbrechen bzw. zu schließen.

Die Steuer- und Überwachungsschaltung eines so gebildeten elektro-mechanischen Schalters 100 ist nach einer weiteren Ausgestaltung der Erfindung ferner dafür eingerichtet, eine ein Versagen nämlichen Schalters - etwa infolge eines sowohl bei den ersten Signalpegelwert aufweisendem Schaltsignal als auch bei den zweiten Signalpegelwert aufweisendem Schaltsignal in erster Endlage verharrenden Ankers bzw. infolge eines sowohl bei den ersten Signalpegelwert aufweisendem Schaltsignal als auch bei den zweiten Signalpegelwert aufweisendem Schaltsignal in zweiter Endlage verharrenden Ankers - signalisierende Warnmeldung zu generieren, falls im Ergebnis der von der Steuer- und Überwachungsschaltung unter Verwendung des Strommeßsignals durchgeführten Überprüfung der Spule ein Defekt nämlicher Spule festgestellt ist.

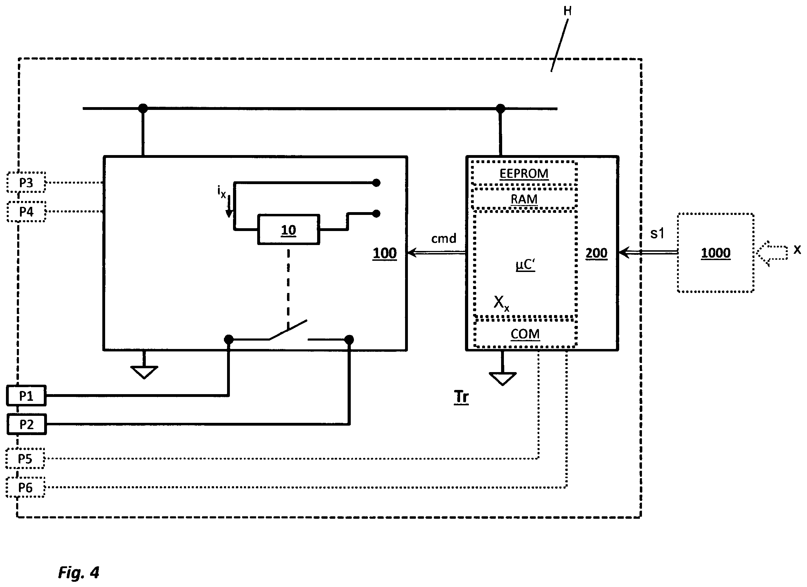

Nach einer weiteren Ausgestaltung der Erfindung ist die Spulenanordnung 10 bzw. der damit gebildete elektro-mechanischen Schalter 100 als ein Bestandteil eines Meßumformers Tr ausgebildet (Fig. 4). Nämlicher Meßumformer umfaßt, wie in Fig. 4 schematisch dargestellt bzw. aus einer Zusammenschau der Fig. 3 und 4 bzw. der Fig. 1, 3 und 4 ohne weiteres ersichtlich (zusätzlich zur Spulenanordnung 10 bzw. zum damit gebildeten elektro-mechanischen Schalter) eine, beispielsweise mittels eines Mikroprozessors µC' gebildete und/oder von der Betriebsschaltung 50 gespeiste, Meßschaltung 200 zum Empfangen wenigstens eines von einer physikalischen oder chemischen Meßgröße x - beispielsweise nämlich einer Massendurchflußrate, einer Volumendurchflußrate, einer Dichte, einer Viskosität, einer Temperatur oder eines Drucks eines in einer Rohrleitung geführten und/oder in einem Behälter vorgehaltenen Fluids - abhängigen und/oder einen zeitlichen Verlauf nämlicher Meßgröße x repräsentierenden, beispielsweise elektrischen und/oder analogen, Aufnehmersignals s1. Die Meßschaltung 200 des Meßumformers Tr ist nach eine weiteren Ausgestaltung der Erfindung dafür vorgesehen bzw. eingerichtet, im Betrieb unter Verwendung des Aufnehmersignals s1 wiederkehrend Meßwerte für die Meßgröße x zu ermitteln, beispielsweise auch inform von zyklisch bzw. in Echtzeit generierten Digitalwerten.

Nach einer anderen Ausgestaltung der Erfindung umfaßt der vorbezeichnete Meßumformer Tr ferner ein - beispielsweise hermetisch dichtes und/oder explosionsfestes - Umformer-Gehäuse H, innerhalb dem, wie auch in Fig. 4 schematisch dargestellt, sowohl die Meßschaltung 200 als auch die Spulenanordnung bzw. der damit gebildete elektro-mechanische Schalter 100 plaziert sind.

Im besonderen ist hierbei ferner vorgesehen, mittels des Schalters 100 einen Schalt- oder Relaisausgang nämlichen Meßumformers Tr zu bilden, mithin den Schalter 100 dafür zu verwenden, einen teilweise extern des Meßumformers verlaufenden, beispielsweise über Anschlußklemmen P1, P2 geführten, Stromkreis zu schalten, nämlich wahlweise zu- bzw. abzuschalten. Das Schalten nämlichen Stromkreises kann beispielsweise dazu dienen, ein binäres Signal zu erzeugen bzw. auszugeben., etwa zur Vermeldung eines Betriebszustandes des Meßgeräts und/oder zur Übermittlung einer Fehlermeldung bzw. eines Alarms an eine entfernte Meldeeinrichtung. Der als Bestandteil des Meßumformers Tr ausgebildete elektro-mechanische Schalter kann ferner beispielsweise auch dafür eingerichtet sein, in Abhängigkeit von der Meßgröße x bzw. den dafür ermittelten Meßwerten betätigt zu werden, etwa um ein Über- bzw. ein Unterschreiten eines für nämliche Meßgröße x vorab festgelegten Schwellenwerts zu signalisieren bzw. unverzüglich eine entsprechende (Gegen-) Maßnahme einzuleiten, etwa durch An- bzw. Abschalten einer Pumpe oder durch Öffnen- bzw. Schließen eines Ventils etc.. Dementsprechend ist die Meßschaltung nach einer weiteren Ausgestaltung der Erfindung ferner dafür eingerichtet, ein die Steuer- und Überwachungsschaltung instruierendes, beispielsweise nämlich eine Änderung des Signalpegels des Schaltsignals vom ersten Signalpegel auf den zweiten Signalpegel oder eine Änderung des Signalpegels des Schaltsignals vom ersten Signalpegel auf den zweiten Signalpegel veranlassendes und/oder ein digitales, Steuersignal cmd zu generieren bzw. ein solches Steuersignal cmd an die Steuer- und Überwachungsschaltung auszugeben. Im besonderen ist die Meßschaltung ferner eingerichtet, nämliches Steuersignal cmd unter Verwendung des Aufnehmersignals und/oder in Abhängigkeit zumindest eines der Meßwerte zu generieren, beispielsweise nämlich basierend auf einem wiederkehrend durchgeführten Vergleich des Aufnehmersignals bzw. der Meßwerte mit einem dafür entsprechend vorgegebenen Schwellenwert.

Der Meßumformers Tr ist nach einer weiteren Ausgestaltung der Erfindung ferner dafür eingerichtet, von einer an Versorgungsklemmen P3, P4 anschließbare externen - hier nicht gezeigten - Energieversorgung mit elektrischer Energie versorgt zu werden bzw. die im Betrieb benötigte elektrische Leistung zumindest anteilig bzw. zumindest zeitweise von nämlicher externen Energieversorgung zu beziehen.

Zwecks Vermittlung eines Ergebnisses einer allfälligen Überprüfung der Spule, beispielsweise an einen nämliche Überprüfung veranlassende Anwender bzw. damit beauftragtes Servicepersonal, umfaßt der Meßumformer nach einer weiteren Ausgestaltung der Erfindung ferner ein von der Steuer- und Überwachungsschaltung 40 angesteuertes, beispielsweise mittels einer Flüssigkeitskristallanzeige (LCD) und/oder einer Leuchtdiode (LED) gebildetes, Anzeigeelement 60. Im besonderen ist die Steuer- und Überwachungsschaltung 40 hierbei ferner dafür eingerichtet, ein Ergebnis der Überprüfung der Spule, beispielsweise inform eines binären oder digitalen Statussignals, an das Anzeigeelement 60 zu übermitteln bzw. ist das Anzeigeelement dafür eingerichtet ist, nämliches Ergebnis visuell wahrnehmbar anzuzeigen. Darüberhinaus kann das Anzeigeelement 60 auch dazu verwendet werden, einen momentanen Schaltzustandes des elektronischen Schalters 30 bzw. einen momentanen Signalpegelwert des Schaltsignals ctrl zur Anzeige zu bringen. Ferner kann das Anzeigeelement 60 beispielsweise auch dafür vorgesehen bzw. kann der Meßumformer eingerichtet sein, mittels der Meßschaltung 200 generierte Meßwerte anzuzeigen.

In vorteilhafter Weise kann der, beispielsweise auch fernparametrierbare, Meßumformer Tr ferner so ausgelegt sein, daß er im Betrieb mit einem übergeordneten elektronischen Datenverarbeitungssystem, beispielsweise einer speicherprogrammierbaren Steuerung (SPS), einem Personalcomputer und/oder einer Workstation, via Datenübertragungssystem, beispielsweise drahtgebunden (P5, P6) via seriellem Feldbus (PROFIBUS, FOUNDATION FIELDBUS, etc.) bzw. Ethernet und/oder drahtlos per Funk, Meß- und/oder Betriebsdaten, ggf. auch in Echtzeit, austauschen kann, wie etwa der Steuerung des Meßumformers bzw. einem damit gebildeten Meßgerät dienende Einstellwerte bzw. aktuelle Meß- und/oder Systemdiagnosewerte. Im besonderen kann der Meßumformer Tr ferner auch dafür eingerichtet sein, ein Ergebnis der Überprüfung der Spule an nämliches Datenverarbeitungssystem zu übermitteln, beispielsweise inform eines binären oder digitalen Statussignals oder auch inform eines mittels des Datenverarbeitungssystem lesbaren, ggf. auch mit einem zyklischen Datenübertragungsverfahren bzw. in Echtzeit übermittelten Telegramms.

Die Meßschaltung des vorbezeichneten Meßumformers Tr ist nach einer weiteren Ausgestaltung der Erfindung und wie in Fig. 4 schematisiert dargestellt unter Bildung eines, beispielsweise auch für die industrielle Meß- und Automatisierungstechnik geeigneten, Meßgeräts an einen, beispielsweise als ein physikalisch-zu-elektrischer Wandler ausgebildeten, Meßaufnehmer 1000 elektrisch gekoppelt. Der Meßaufnehmer 1000 dient hierbei im besonderen dazu, eine, insb. lediglich innerhalb eines vorgegebenen Meßbereichs, zeitlich veränderliche physikalische und/oder chemische Meßgröße x - beispielsweise nämlich eine Massendurchflußrate, eine Volumendurchflußrate, eine Dichte, eine Viskosität, eine Temperatur, oder einen Drucks eines in einer Rohrleitung geführten und/oder in einem Behälter vorgehaltenen Fluids - zu erfassen und zwecks Generieren eines nämliche Meßgröße x repräsentierenden, insb. elektrischen und/oder digitalen, Aufnehmersignals s1 physikalisch zu elektrisch zu wandeln, ggf. auch bereits zeit- und wertediskret abzutasten bzw. zu digitalisieren.

## Patentansprüche

1. Spulenanordnung, umfassend:
- eine elektrische Spule (10)
-- mit einem Spulenkern (11),
-- und mit einem nämlichen Spulenkern umgebenden Stromleiter (12),
- einen zwischen einer ersten Endlage (I) und einer zweiten Endlage (II) bewegbaren Anker (20) aus einem eine Permeabilitätszahl, µᵣ, von mehr als 10 (µᵣ > 10) aufweisenden Material;
- einen zwischen wenigstens zwei Schaltzuständen umschaltbaren elektronischen Schalter (30);
- eine Steuer- und Überwachungsschaltung (40) zum Erzeugen eines den elektronischen Schalter (30) betätigenden Schaltsignals (ctrl) mit einem veränderlichen Signalpegel;
- sowie eine Betriebsschaltung (50) zum Bereitstellen einer Betriebsspannung (U_{N});
- wobei mittels des Spulenkerns (11) und mittels des Ankers (20) ein Magnetkreis gebildet ist, derart, daß nämlicher Magnetkreis einen von einer Lage des Ankers abhängigen magnetischen Widerstand, Rₘ, aufweist, derart, daß nämlicher magnetischer Widerstand, Rₘ, bei in erster Endlage (I) befindlichem Anker kleiner ist als bei in zweiter Endlage befindlichem Anker, und daß die Spule eine von der Lage des Ankers abhängige Induktivität, L, aufweist, derart, daß nämliche Induktivität, L, bei in erster Endlage (I) befindlichem Anker größer ist als bei in zweiter Endlage befindlichem Anker;
- wobei die Spule (10) dafür eingerichtet ist, im Stromleiter (12) einen elektrischen Strom (iₓ) zu führen und nämlichen Strom in eine zwischen deren Spulenkern (11) und dem Anker (20) wirkende, gleichwohl von einer Stromstärke des Stroms (iₓ) abhängige Magnetkraft zu wandeln;
- **dadurch gekennzeichnet, dass** der elektronische Schalter (30) dafür eingerichtet ist,
-- in einem ersten Schaltzustand einen mittels der Betriebsschaltung, der Spule sowie dem elektronische Schalter gebildeten Spulen-Stromkreis zu schließen, derart, daß ein einem dann von der Betriebsspannung getriebenen, in nämlichem Spulen-Stromkreis fließenden elektrischen Strom (iₓ) entgegenwirkender elektrischer Widerstand, R, des Spulen-Stromkreises dann einen ersten Widerstandswert aufweist,
-- und in einem zweiten Schaltzustand nämlichen Spulen-Stromkreis zu öffnen, derart, daß dessen elektrischer Widerstand dann einen zweiten Widerstandswert, der größer als der erste Widerstandswert ist, aufweist;
- wobei die Betriebsschaltung (50) dafür eingerichtet ist, ein einen zeitlichen Verlauf des im Spulen-Stromkreis fließenden elektrischen Stroms repräsentierendes Strommeßsignal (i_{M}) bereitzustellen;
- wobei die Steuer- und Überwachungsschaltung (40) dafür eingerichtet ist, das Schaltsignal (ctrl) zeitweise mit einem den ersten Schaltzustand des elektronischen Schalters veranlassenden ersten Signalpegelwert bereitzustellen;
- wobei die Steuer- und Überwachungsschaltung (40) dafür eingerichtet ist, das Schaltsignal zeitweise mit einem den zweiten Schaltzustand des elektronischen Schalters veranlassenden, vom ersten Signalpegelwert verschiedenen zweiten Signalpegelwert bereitzustellen;
- und wobei die Steuer- und Überwachungsschaltung (40) dafür eingerichtet ist, unter Verwendung des Strommeßsignals (i_{M}) eine Überprüfung der Spule (10) durchzuführen, nämlich
-- festzustellen, ob die Induktivität, L, der Spule (10) eine Abhängigkeit von einem zeitlichen Verlauf des Schaltsignals (ctrl) bzw. einen mit dem zeitlichen Verlauf des Schaltsignals korrespondierenden zeitlichen Verlauf aufweist, und/oder
-- festzustellen, ob die Spule (10) auf eine Änderung des Signalpegels des Schaltsignals (ctrl) vom ersten Signalpegel auf den zweiten Signalpegel mit einer Änderung, nämlich mit einer Erhöhung von deren Induktivität, L, reagiert, und/oder
-- festzustellen, ob die Spule (10) auf eine Änderung des Signalpegels des Schaltsignals (ctrl) vom zweiten Signalpegel auf den ersten Signalpegel mit einer Änderung, nämlich mit einer Verringerung von deren Induktivität, L, reagiert.

2. Spulenanordnung gemäß einem der vorherigen Ansprüche,
- wobei die Steuer- und Überwachungsschaltung dafür eingerichtet ist, unter Verwendung des Strommeßsignals einen Defekt der Spule bzw. der Spulenanordnung, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, zu detektieren; und/oder
- wobei die die Steuer- und Überwachungsschaltung dafür eingerichtet ist, die Überprüfung der Spule unter Verwendung eines digitalisierten Strommeßsignals, nämlich eines den zeitlichen Verlauf des im Spulen-Stromkreis fließenden elektrischen Stroms repräsentierenden Digitalsignals durchzuführen; und/oder
- wobei die Steuer- und Überwachungsschaltung dafür eingerichtet ist, ein Ergebnis der Überprüfung der Spule, insb. inform eines binären oder digitalen Statussignals, auszugeben; und/oder
- wobei die Steuer- und Überwachungsschaltung dafür eingerichtet ist, im Ergebnis der Überprüfung der Spule eine eine, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, defekte Spule signalisierende Nachricht zu generieren, falls eine mit einer defekten Spule korrespondierende Überschreitung eines vorgegebenen, insb. vorab in der Steuer- und Überwachungsschaltung abgespeicherten und/oder eine Intervallgrenze für einen mit einer defekten Spule korrespondierenden Wertebereich repräsentierenden, Schwellenwerts ermittelt ist; und/oder
- wobei die Steuer- und Überwachungsschaltung dafür eingerichtet ist, ein von einem Ergebnis der Überprüfung der Spule abhängiges bzw. nämliches Ergebnis vermeldendes, insb. binäres oder digitales, Statussignal (msg) bereitzustellen; und/oder
- wobei die Steuer- und Überwachungsschaltung einen Analog-zu-Digital-Wandler aufweist, der dafür eingerichtet ist, das Strommeßsignal zu empfangen und zu digitalisieren; und/oder
- wobei die Betriebsschaltung dafür eingerichtet, das Strommeßsignal digitalisiert, nämlich inform eines den zeitlichen Verlauf des im Spulen-Stromkreis fließenden elektrischen Stroms repräsentierenden Digitalsignals auszugeben.

3. Spulenanordnung gemäß einem der vorherigen Ansprüche,
- wobei die Steuer- und Überwachungsschaltung (40) einen Mikroprozessor (µC) aufweist
- und wobei die Steuer- und Überwachungsschaltung dafür eingerichtet ist:
-- das Schaltsignal mittels des Mikroprozessors zu generieren; und/oder
-- die Überprüfung der Spule mittels des Mikroprozessors durchzuführen; und/oder
-- das Strommeßsignal mittels des Mikroprozessors zu verarbeiten.

4. Spulenanordnung gemäß einem der vorherigen Ansprüche, wobei die Steuer- und Überwachungsschaltung einen flüchtigen Datenspeicher (RAM) aufweist und dafür eingerichtet ist, das Strommeßsignal zumindest auszugsweise in nämlichen Datenspeicher abzuspeichern, derart, daß im Datenspeicher zumindest vorübergehend zumindest eine Sequenz von digitalen Stromwerten, nämlich Digitalwerten eines digitalisierten Strommeßsignals, vorgehalten ist, insb. nämlich derart, daß zumindest vorübergehend eine einen Ausschaltvorgang der Spule, nämlich den zeitlichen Verlauf des in der Spule fließenden Stromes nach einem Wechsel des elektronischen Schalters vom ersten Schaltzustand in den zweiten Schaltzustand repräsentierende Sequenz von digitalen Stromwerten (Ausschaltstromkurve) im Datenspeicher abgespeichert ist und/oder daß zumindest vorübergehend eine einen Einschaltvorgang der Spule, nämlich den zeitlichen Verlauf des in der Spule fließenden Stromes nach einem Wechsel des elektronischen Schalters vom zweiten Schaltzustand in den ersten Schaltzustand repräsentierende Sequenz von digitalen Stromwerten (Einschaltstromkurve) im Datenspeicher abgespeichert ist.

5. Spulenanordnung gemäß einem der vorherigen Ansprüche, wobei die Steuer- und Überwachungsschaltung dafür eingerichtet ist, anhand des Strommeßsignals, insb. wiederkehrend, einen Stromdynamik-Kennwert, nämlich einen Kennzahlenwert für eine den zeitlichen Verlauf des in der Spule fließenden Stromes, insb. nach einem Wechsel des elektronischen Schalters vom ersten Schaltzustand in den zweiten Schaltzustand oder nach einem Wechsel des elektronischen Schalters vom zweiten Schaltzustand in den ersten Schaltzustand, charakterisierende Kenngröße, insb. nämlich eine Änderungsrate des Stromes oder eine ausgehend von einem Startzeitpunkt bis zum Erreichen eines vorgegebenen Stromwerts erforderliche Zeitspanne, zu ermitteln, insb. nämlich zu berechnen.

6. Spulenanordnung gemäß Anspruch 4 und 5, wobei die Steuer- und Überwachungsschaltung dafür eingerichtet ist, den Stromdynamik-Kennwert unter Verwendung von im flüchtigen Datenspeicher (RAM) vorgehaltenen digitalen Stromwerten zu ermitteln, insb. nämlich unter Verwendung einer im flüchtigen Datenspeicher (RAM) zumindest vorübergehend vorgehaltenen einen Ausschaltvorgang der Spule repräsentierenden Sequenz von digitalen
Stromwerten (Ausschaltstromkurve) und/oder unter Verwendung einer im flüchtigen Datenspeicher (RAM) zumindest vorübergehend vorgehaltenen einen Einschaltvorgang der Spule repräsentierende Sequenz von digitalen Stromwerten (Einschaltstromkurve).

7. Spulenanordnung gemäß dem vorherigen Anspruch, wobei die Steuer- und Überwachungsschaltung dafür eingerichtet ist, den Stromdynamik-Kennwert durch Aufsummieren einer vorgegebenen Anzahl von digitalen Stromwerten, beginnend mit einem einen zu einem vorgegebenen und/oder im Betrieb ermittelten Startzeitpunkt im Spulen-Stromkreis fließenden Strom repräsentierendenden Anfangsstromwert.

8. Spulenanordnung gemäß einem der Ansprüche 5 bis 7, wobei die Steuer- und Überwachungsschaltung dafür eingerichtet ist, den Stromdynamik-Kennwert durch Integrieren eines einen zeitlichen Verlauf des Stromes innerhalb eines vorgegebenen Zeitintervalls repräsentierenden Teilabschnitts des Strommeßsignals zu ermitteln.

9. Spulenanordnung gemäß einem der Ansprüche 5 bis 8, wobei die Steuer- und Überwachungsschaltung dafür eingerichtet ist, zur Überprüfung der Spule eine Abweichung zwischen dem Stromdynamik-Kennwert mit einem dafür vorgegebenen, insb. vorab gemessenen und/oder in der Überwachungsschaltung abgespeicherten Referenzwert zu ermitteln, insb. nämlich zu berechnen.

10. Spulenanordnung gemäß dem vorherigen Anspruch, wobei die Steuer- und Überwachungsschaltung dafür eingerichtet ist, zur Überprüfung der Spule nämliche Abweichung mit einem dafür vorgegebenen, insb. vorab in der Steuer- und Überwachungsschaltung abgespeicherten und/oder eine Intervallgrenze für einen mit einer defekten Spule korrespondierenden Wertebereich der den zeitlichen Verlauf des in der Spule fließenden Stromes charakterisierende Kenngröße repräsentierenden, Schwellenwert (THR) zu vergleichen.

11. Spulenanordnung gemäß dem vorherigen Anspruch,
- wobei die Steuer- und Überwachungsschaltung einen nicht-flüchtigen Datenspeicher (EEPROM) aufweist,
- und wobei der Schwellenwert (THR) im nicht-flüchtigen Datenspeicher (EEPROM) abgespeichert ist.

12. Spulenanordnung gemäß einem der vorherigen Ansprüche, wobei die Betriebsschaltung (50) einen, insb. in Spulen-Stromkreis eingegliederten, insb. zur Spule elektrisch in Reihe geschalteten, Meßwiderstand (Rsens) zum Bereitstellen einer zu dem im Spulen-Stromkreis fließenden elektrischen Strom proportionalen Meßspannung aufweist,

13. Spulenanordnung gemäß dem vorherigen Anspruch,
- wobei die Betriebsschaltung einen Analog-zu-Digitalwandler zum Digitalisieren der mittels des Meßwiderstands bereitgestellten Meßspannung aufweist, insb. nämlich dafür dafür eingerichtet, die digitalisierte Meßspannung als Strommeßsignal auszugeben; und/oder
- wobei die die Betriebsschaltung dafür eingerichtet ist, das Strommeßsignals mittels der Meßspannung zu generieren; und/oder
- wobei die die Betriebsschaltung dafür eingerichtet ist, die Meßspannung als, insb. digitalisiertes, Strommeßsignal auszugeben.

14. Spulenanordnung gemäß einem der vorherigen Ansprüche, weiters umfassend: eine mit dem Anker mechanisch gekoppelte Rückstellfeder, die dafür eingerichtet ist, eine der Magnetkraft entgegenwirkende Rückstellkraft in den Anker einzuleiten.

15. Elektro-mechanischer Schalter (100), umfassend:
- einen zwischen einer ersten Schaltstellung (i) und einer zweiten Schaltstellung (ii) bewegbaren, insb. federelastischen, ersten Schaltkontakt (101)
- einen zweiten Schaltkontakt (102);
- und zum Betätigen des ersten Schaltkontakts eine Spulenanordnung gemäß einem der vorherigen Ansprüche;
- wobei der Anker (20) der Spulenanordnung dafür eingerichtet ist, bei einem Wechsel aus dessen erster Endlage (I) in dessen zweite Endlage (II) den ersten Schaltkontakt (101) aus dessen erster Schaltstellung (i) in dessen zweite Schaltstellung (ii) zu bewegen,
- wobei der erste Schaltkontakt dafür eingerichtet ist, in erster Schaltstellung vom zweiten Schaltkontakt unter Bildung einer hochohmigen bzw. elektrisch isolierenden Luftstrecke beabstandet zu sein,
- wobei der erste Schaltkontakt dafür eingerichtet ist, in zweiter Schaltstellung den zweiten Schaltkontakt unter Bildung einer niederohmigen bzw. elektrisch leitfähigen Verbindung zu berühren,
- und wobei die Steuer- und Überwachungsschaltung dafür eingerichtet ist, eine ein Versagen des elektro-mechanischen Schalters, insb. infolge eines sowohl bei den ersten Signalpegelwert aufweisendem Schaltsignal als auch bei den zweiten Signalpegelwert aufweisendem Schaltsignal in erster Endlage verharrenden Ankers oder infolge eines sowohl bei den ersten Signalpegelwert aufweisendem Schaltsignal als auch bei den zweiten Signalpegelwert aufweisendem Schaltsignal in zweiter Endlage verharrenden Ankers, signalisierende Warnmeldung zu generieren, falls im Ergebnis der unter Verwendung des Strommeßsignals durchgeführten Überprüfung der Spule ein Defekt nämlicher Spule festgestellt ist.

16. Meßumformer (Tr), umfassend:
- einen elektro-mechanischen Schalter (100) gemäß dem vorherigen Anspruch;
- sowie eine, insb. mittels eines Mikroprozessors gebildete und/oder von der Betriebsschaltung (50) gespeiste, Meßschaltung zum Empfangen wenigstens eines von einer physikalischen oder chemischen Meßgröße abhängigen und/oder einen zeitlichen Verlauf nämlicher Meßgröße (x) repräsentierenden, insb. elektrischen, Aufnehmersignals (s1).

17. Meßumformer gemäß dem vorherigen Anspruch,
- weiters umfassend: ein Umformer-Gehäuse, wobei sowohl die Meßschaltung als auch der elektro-mechanische Schalter innerhalb des Umformer-Gehäuses plaziert sind; und/oder
- weiters umfassend: ein von der Steuer- und Überwachungsschaltung (40) angesteuertes, insb. innerhalb eines Umformer-Gehäuses des Meßumformers plaziertes, Anzeigeelement (60), wobei die Steuer- und Überwachungsschaltung (40) dafür eingerichtet ist, ein Ergebnis der Überprüfung der Spule, insb. inform eines binären oder digitalen Statussignals, an das Anzeigeelement (60) zu übermitteln, und wobei das Anzeigeelement (60) dafür eingerichtet ist, nämliches Ergebnis visuell wahrnehmbar anzuzeigen.

18. Meßumformer gemäß einem der Ansprüche 16 bis 17,
- wobei die Meßschaltung dafür eingerichtet ist, ein die Steuer- und Überwachungsschaltung instruierendes, insb. nämlich eine Änderung des Signalpegels des Schaltsignals vom ersten Signalpegel auf den zweiten Signalpegel oder eine Änderung des Signalpegels des Schaltsignals vom ersten Signalpegel auf den zweiten Signalpegel veranlassendes und/oder ein digitales, Steuersignal zu generieren, insb. nämlich das Steuersignal unter Verwendung des Aufnehmersignals und/oder in Abhängigkeit zumindest eines der Meßwerte zu generieren; und/oder
- wobei die Meßschaltung dafür eingerichtet ist, unter Verwendung des Aufnehmersignals Meßwerte (s1) für die Meßgröße zu ermitteln; und/oder
- wobei mittels des elektro-mechanischen Schalters (100) ein Schaltausgang des Meßumformers gebildet ist, insb. nämlich ein Schaltausgang, der dafür eingerichtet ist, einen teilweise extern des Meßumformers verlaufenden Stromkreis zu schalten.

19. Meßgerät, umfassend:
- einen Meßumformer (Tr) gemäß einem der Ansprüche 16 bis 18;
- sowie einen mit der Meßschaltung nämlichen Meßumformers elektrisch gekoppelten Meßaufnehmer (1000) zum Erfassen einer, insb. lediglich innerhalb eines vorgegebenen Meßbereichs, zeitlich veränderlichen physikalischen und/oder chemischen Meßgröße (x) und zum Generieren des wenigstens einen Aufnehmersignals.

## Claims

1. A coil arrangement, comprising:
- An electric coil (10)
-- with a coil core (11),
-- and with a conductor (12) surrounding said coil core,
- an armature (20) which can be moved between a first end position (I) and a second end position (II) and is made from a material with a permeability number, µᵣ, of more than 10 (µᵣ > 10);
- an electronic switch (30) which can be switched between at least two switching states;
- a control and monitoring circuit (40) for generating a switching signal (ctrl) which activates the electronic switch (30) with a varying signal level;
- and an operating circuit (50) for supplying an operating voltage (U_{N});
- wherein the coil core (11) and armature (20) form a magnetic circuit in such a way that said magnetic circuit has a magnetic resistance, Rₘ, which is dependent on a position of the armature in such a way that said magnetic resistance, Rₘ, is less when the armature is located in the first end position (l) than when the armature is located in the second end position, and in such a way that the coil has an inductance, L, which is dependent on the position of the armature in such a way that said inductance, L, is greater when the armature is located in the first end position (I) than when the armature is located in the second end position;
- wherein the coil (10) is configured to conduct an electric current (iₓ) in the conductor (12) and to convert said current into a magnetic force which acts between its coil core (11) and the armature (20) but is dependent on a current strength of the current (iₓ);
**characterized in that** the electronic switch (30) is configured,
-- in a first switching state, to close a coil circuit formed by the operating circuit, the coil and the electronic switch in such a way that an electrical resistance, R, of the coil circuit counteracting an electric current (iₓ), flowing in said coil circuit, then powered by the operating voltage then has a first resistance value,
-- and in a second switching state, to open said coil circuit in such a way that its electrical resistance then has a second resistance value that is higher than the first resistance value;
- wherein the operating circuit (50) is configured to supply a current measurement signal (i_{M}) representing a chronological progression of the electric current flowing in the coil circuit;
- wherein the control and monitoring circuit (40) is configured to supply the switching signal (ctrl) occasionally with a first signal level value initiating the first switching state of the electronic switch;
- wherein the control and monitoring circuit (40) is configured to supply the switching signal occasionally with a second signal level value initiating the second switching state of the electronic switch which is different from the first signal level value;
- and wherein the control and monitoring circuit (40) is configured to check the coil (10) using the current measurement signal (i_{M}), that is to say
-- to detect whether the inductance, L, of the coil (10) is dependent on a chronological progression of the switching signal (ctrl) and/or on a chronological progression corresponding to the chronological progression of the switching signal, and/or
-- to detect whether the coil (10) responds to a change in the signal level of the switching signal (ctrl) from the first signal level to the second signal level by changing, that is to say by increasing, its inductance, L, and/or
-- to detect whether the coil (10) responds to a change in the signal level of the switching signal (ctrl) from the second signal level to the first signal level by changing, that is to say by reducing, its inductance, L.

2. The coil arrangement as claimed in one of the preceding claims,
- wherein the control and monitoring circuit is configured to detect a defect in the coil and/or the coil arrangement using the current measurement signal, in particular as a result of an armature sticking in the first end position both during the switching signal with the first signal level value and during the switching signal with the second signal level value, or as a result of an armature sticking in the second end position both during the switching signal with the first signal level value and during the switching signal with the second signal level value; and/or
- wherein the control and monitoring circuit is configured to check the coil using a digitized current measurement signal, that is to say a digital signal representing the chronological progression of the electric current flowing in the coil circuit; and/or
- wherein the control and monitoring circuit is configured to output a result of the check of the coil, in particular in the form of a binary or digital status signal; and/or
- wherein the control and monitoring circuit is configured to generate a notification signaling a defective coil as a result of the check of the coil, in particular as a result of an armature sticking in the first end position both during the switching signal with the first signal level value and during the switching signal with the second signal level value, or as a result of an armature sticking in the second end position both during the switching signal with the first signal level value and during the switching signal with the second signal level value, if it is detected that a specified threshold value corresponding to a defective coil, in particular a threshold value stored in the control and monitoring circuit in advance and/or representing an interval boundary for a value range corresponding to a defective coil, is exceeded; and/or
- wherein the control and monitoring circuit is configured to supply an, in particular binary or digital, status signal (msg) which depends on a result of the check of the coil and/or reports said result; and/or
- wherein the control and monitoring circuit has an analog-to-digital converter which is configured to receive and digitize the current measurement signal; and/or
- wherein the operating circuit is configured to output the current measurement signal in digitized form, that is to say in the form of a digital signal representing the chronological progression of the electric current flowing in the coil circuit.

3. The coil arrangement as claimed in one of the preceding claims,
- wherein the control and monitoring circuit (40) has a microprocessor (µC)
- and wherein the control and monitoring circuit is configured:
-- To generate the switching signal using the microprocessor; and/or
-- to check the coil using the microprocessor; and/or
-- to process the current measurement signal using the microprocessor.

4. The coil arrangement as claimed in one of the preceding claims,
- wherein the control and monitoring circuit has a volatile memory (RAM) and is configured to store at least segments of the current measurement signal in said memory in such a way that the memory stores, at least temporarily, at least one sequence of digital current values, that is to say digital values of a digitized current measurement signal, that is to say, in particular, in such a way that a sequence of digital current values (switch-off curve) representing a switch-off process of the coil, that is to say the chronological progression of the current flowing in the coil after the electronic switch changes from the first switching state to the second switching state is stored, at least temporarily, in the memory and/or in such a way that a sequence of digital current values (switch-on curve) representing a switch-on process of the coil, that is to say the chronological progression of the current flowing in the coil after the electronic switch changes from the second switching state to the first switching state is stored, at least temporarily, in the memory.

5. The coil arrangement as claimed in one of the preceding claims,
- wherein the control and monitoring circuit is configured to determine, that is to say, in particular, to calculate, based on the current measurement signal, in particular on a recurrent basis, a current dynamics characteristic value, that is to say a characterizing number value for a characteristic variable representing the chronological progression of the current flowing in the coil, in particular after the electronic switch changes from the first switching state to the second switching state, or after the electronic switch changes from the second switching state to the first switching state, that is to say, in particular, a rate at which the current changes or a time period required from a start point until a specified current value is reached.

6. The coil arrangement as claimed in claims 4 and 5,
- wherein the control and monitoring circuit is configured to determine the current dynamics characteristic value using digital current values stored in the volatile memory (RAM), that is to say, in particular, using a sequence of digital current values (switch-off current curve) stored, at least temporarily, in the volatile memory (RAM) and representing a switch-off process of the coil and/or using a sequence of digital current values (switch-on curve) stored, at least temporarily, in the volatile memory (RAM) and representing a switch-on process of the coil.

7. The coil arrangement as claimed in the preceding claim
- wherein the control and monitoring circuit is configured to determine the current dynamics characteristic value by adding together a specified number of digital current values, beginning with a starting current value representing a current flowing in the coil circuit at a specified start point and/or at a start point determined during operation.

8. The coil arrangement as claimed in one of claims 5 to 7,
- wherein the control and monitoring circuit is configured to determine the current dynamics characteristic value by integrating a segment of the current measurement signal representing a chronological progression of the current within a specified time interval.

9. The coil arrangement as claimed in one of claims 5 to 8,
- wherein the control and monitoring circuit is configured to determine, that is to say, in particular, to calculate, a difference between the current dynamics characteristic value and a reference value specified for this, in particular measured in advance and/or stored in the monitoring circuit, in order to check the coil.

10. The coil arrangement as claimed in the preceding claim,
- wherein the control and monitoring circuit is configured, for the purpose of checking the coil, to compare said difference with a threshold value (THR) specified for this, in particular stored in the control and monitoring circuit in advance and/or representing an interval boundary for a value range of the characterizing variable representing the chronological progression of the current flowing in the coil corresponding to a defective coil.

11. The coil arrangement as claimed in the preceding claim,
- wherein the control and monitoring circuit has a non-volatile memory (EEPROM),
- and wherein the threshold value (THR) is stored in the non-volatile memory (EEPROM).

12. The coil arrangement as claimed in one of the preceding claims,
- wherein the operating circuit (50) has a shunt resistor (Rsens), in particular incorporated into the coil circuit, in particular electrically connected in series, to supply a measuring voltage proportional to the electric current flowing in the coil circuit.

13. The coil arrangement as claimed in the preceding claim,
- wherein the operating circuit has an analog-to-digital converter for digitizing the measuring voltage supplied by means of the shunt resistor, that is to say, in particular, is configured to output the digitized measuring voltage as a current measurement signal; and/or
- wherein the operating circuit is configured to generate the current measurement signal by means of the measuring voltage; and/or
- wherein the operating circuit is configured to output the measuring voltage as an, in particular digitized, current measurement signal.

14. The coil arrangement as claimed in one of the preceding claims, further comprising:
A return spring mechanically coupled to the armature, which is configured to initiate a return force counteracting the magnetic force in the armature.

15. An electromechanical switch (100), comprising:
- A first switching contact (101), in particular a resilient one, which can be moved between a first switching position (i) and a second switching position (ii);
- a second switching contact (102);
- and a coil arrangement as claimed in one of the preceding claims for actuating the first switching contact;
- wherein the armature (20) of the coil arrangement is configured to move the first switching contact (101) from its first switching position (i) to its second switching position (ii) when the armature changes from its first end position (I) to its second end position (II),
- wherein the first switching contact is configured to be spaced apart from the second switching contact in the first switching position, forming a high-resistance and/or electrically insulating air gap,
- wherein the first switching contact is configured to touch the second switching contact in the second switching position, forming a low-resistance and/or electrically conductive air gap,
- and wherein the control and monitoring circuit is configured to generate a warning message signaling a failure of the electromagnetic switch, in particular as a result of an armature sticking in the first end position both during the switching signal with the first signal level value and during the switching signal with the second signal level value, or as a result of an armature sticking in the second end position both during the switching signal with the first signal level value and during the switching signal with the second signal level value, if the result of the check of the coil performed using the current measurement signal indicates that said coil is defective.

16. A transmitter (Tr), comprising:
- An electromechanical switch (100) as claimed in the preceding claim;
- and a measuring circuit, in particular formed by a microprocessor and/or powered by the operating circuit (50), for receiving at least one, in particular electrical, sensor signal (s1) dependent on a physical or chemical measured variable and/or representing a chronological progression of said measured variable (x).

17. The transmitter as claimed in the preceding claim,
- further comprising: A transmitter housing, wherein both the measuring circuit and the electromechanical switch are located inside the transmitter housing; and/or
- further comprising: A display element (60) activated by the control and monitoring circuit (40), in particular located inside a transmitter housing of the transmitter, wherein the control and monitoring circuit (40) is configured to transmit a result of the check of the coil, in particular in the form of a binary or digital status signal, to the display element (60), and wherein the display element (60) is configured to visually display said result.

18. The transmitter as claimed in one of claims 16 and 17,
- wherein the measuring circuit is configured to generate a control signal instructing the control and monitoring circuit, that is to say, in particular, causing the signal level of the switching signal to change from the first signal level to the second signal level, or causing the signal level of the switching signal to change from the first signal level to the second signal level, and/or a digital control signal, that is to say, in particular, to generate the control signal using the sensor signal and/or as a function of at least one of the measured values; and/or
- wherein the measuring circuit is configured to determine measured values (s1) for the measured variable using the sensor signal; and/or
- wherein the electromechanical switch (100) is used to form a switching output of the transmitter, that is to say, in particular, a switching output which is configured to switch a circuit which runs partially outside the transmitter.

19. A measuring device, comprising:
- A transmitter (Tr) as claimed in one of claims 16 to 18;
- and a sensor (1000) electrically coupled with the measuring circuit of said transmitter for detecting a time-variable physical and/or chemical measured variable (x), in particular only within a specified measuring range, and for generating the at least one sensor signal.

## Revendications

1. Agencement de bobines, comprenant :
- une bobine électrique (10)
-- avec un noyau de bobine (11),
-- et avec un conducteur de courant (12) entourant ledit noyau de bobine,
- une armature (20) mobile entre une première position finale (l) et une deuxième position finale (Il), laquelle armature est réalisée dans un matériau présentant un indice de perméabilité, µᵣ, supérieur à 10 (µᵣ > 10) ;
- un interrupteur électronique (30) pouvant être commuté entre au moins deux états de commutation ;
- un circuit de commande et de surveillance (40) destiné à générer un signal de commutation (ctrl) actionnant l'interrupteur électronique (30) avec un niveau de signal variable ;
- ainsi qu'un circuit d'exploitation (50) destiné à fournir une tension de service (U_{N}) ;
- un circuit magnétique étant formé au moyen du noyau de bobine (11) et de l'armature (20), de telle sorte que ledit circuit magnétique présente une résistance magnétique, Rₘ, dépendant de la position de l'armature, de telle sorte que ladite résistance magnétique, Rₘ, est plus faible lorsque l'armature se trouve dans la première position finale (l) que lorsqu'elle se trouve dans la deuxième position finale, et que la bobine présente une inductance, L, dépendant de la position de l'armature, de telle sorte que ladite inductance, L, est plus grande lorsque l'armature se trouve dans la première position finale (l) que lorsqu'elle se trouve dans la deuxième position finale ;
- la bobine (10) étant conçue pour conduire un courant électrique (iₓ) dans le conducteur de courant (12) et pour convertir ce courant en une force magnétique agissant entre son noyau de bobine (11) et l'armature (20), laquelle force dépend néanmoins de l'intensité du courant (iₓ) ;
- **caractérisé en ce que** l'interrupteur électronique (30) est conçu pour,
-- dans un premier état de commutation, fermer un circuit de bobine formé par le circuit d'exploitation, la bobine et l'interrupteur électronique, de telle sorte qu'une résistance électrique R - s'opposant à un courant électrique circulant dans ledit circuit de bobine sous l'effet de la tension d'alimentation - du circuit de bobine présente alors une première valeur de résistance,
-- et, dans un deuxième état de commutation, ouvrir ledit circuit de bobine, de telle sorte que la résistance électrique dudit circuit de bobine présente alors une deuxième valeur de résistance, qui est supérieure à la première valeur de résistance ;
- le circuit d'exploitation (50) étant conçu pour fournir un signal de mesure de courant (i_{M}) représentant l'évolution dans le temps du courant électrique circulant dans le circuit de bobine ;
- le circuit de commande et de surveillance (40) étant conçu pour fournir temporairement le signal de commutation (ctrl) avec une première valeur de niveau de signal provoquant le premier état de commutation de l'interrupteur électronique ;
- le circuit de commande et de surveillance (40) étant conçu pour fournir temporairement le signal de commutation avec une deuxième valeur de niveau de signal, différente de la première valeur de niveau de signal, provoquant le deuxième état de commutation de l'interrupteur électronique ;
- et le circuit de commande et de surveillance (40) étant conçu pour effectuer, à l'aide du signal de mesure de courant (i_{M}), une vérification de la bobine (10), à savoir
-- pour déterminer si l'inductance, L, de la bobine (10) présente une dépendance vis-à-vis d'une évolution temporelle du signal de commutation (ctrl) ou une évolution temporelle correspondant à l'évolution temporelle du signal de commutation, et/ou
-- pour déterminer si la bobine (10) réagit à un changement du niveau du signal de commutation (ctrl) du premier niveau de signal au deuxième niveau de signal par un changement, à savoir une augmentation de son inductance, L, et/ou
-- pour déterminer si la bobine (10) réagit à un changement du niveau du signal de commutation (ctrl) du deuxième niveau de signal au premier niveau de signal par un changement, à savoir une diminution de son inductance, L.

2. Agencement de bobines selon l'une des revendications précédentes,
- pour lequel le circuit de commande et de surveillance est conçu pour détecter, à l'aide du signal de mesure de courant, un défaut de la bobine ou de l'agencement de bobines, notamment en raison d'une armature restant en première position finale aussi bien lors d'un signal de commutation présentant la première valeur de niveau de signal que lors d'un signal de commutation présentant la deuxième valeur de niveau de signal, ou en raison d'une armature restant en deuxième position finale aussi bien lors d'un signal de commutation présentant la première valeur de niveau de signal que lors d'un signal de commutation présentant la deuxième valeur de niveau de signal, ; et/ou
- pour lequel le circuit de commande et de surveillance est conçu pour effectuer la vérification de la bobine en utilisant un signal de mesure de courant numérisé, à savoir un signal numérique représentant l'évolution dans le temps du courant électrique circulant dans le circuit de la bobine ; et/ou
- pour lequel le circuit de commande et de surveillance est conçu pour fournir un résultat de la vérification de la bobine, notamment sous la forme d'un signal d'état binaire ou numérique ; et/ou
- pour lequel le circuit de commande et de surveillance est conçu pour, à la suite de la vérification de la bobine, générer un message signalant une défaillance de la bobine - notamment en raison d'une armature restant en première position finale tant lors d'un signal de commutation présentant la première valeur de niveau de signal que lors d'un signal de commutation présentant la deuxième valeur de niveau de signal, ou en raison d'une armature restant en deuxième position finale tant lors d'un signal de commutation présentant la première valeur de niveau de signal que lors d'un signal de commutation présentant la deuxième valeur de niveau de signal - si l'on détermine un dépassement d'une valeur seuil prédéfinie, notamment mémorisée au préalable dans le circuit de commande et de surveillance et/ou représentant une limite d'intervalle pour une gamme de valeurs correspondant à une bobine défectueuse ; et/ou
- pour lequel le circuit de commande et de surveillance est conçu pour fournir un signal d'état (msg), notamment binaire ou numérique, lequel signal dépend d'un résultat de la vérification de la bobine ou indique ce résultat ; et/ou
- pour lequel le circuit de commande et de surveillance comporte un convertisseur analogique-numérique, lequel est conçu pour recevoir et numériser le signal de mesure de courant ; et/ou
- pour lequel le circuit d'exploitation est conçu pour délivrer le signal de mesure de courant numérisé, à savoir un signal numérique représentant l'évolution dans le temps du courant électrique circulant dans le circuit de la bobine.

3. Agencement de bobines selon l'une des revendications précédentes,
- pour lequel le circuit de commande et de surveillance (40) comporte un microprocesseur (µC)
- et pour lequel le circuit de commande et de surveillance est conçu pour :
-- générer le signal de commutation au moyen du microprocesseur ; et/ou
-- effectuer la vérification de la bobine au moyen du microprocesseur ; et/ou
-- traiter le signal de mesure de courant au moyen du microprocesseur.

4. Agencement de bobines selon l'une des revendications précédentes, pour lequel le circuit de commande et de surveillance comporte une mémoire de données volatile (RAM) et est conçu pour enregistrer le signal de mesure de courant, au moins par extraits, dans ladite mémoire de données, de telle sorte qu'au moins une séquence de valeurs de courant numériques, à savoir des valeurs numériques d'un signal de mesure de courant numérisé, soit conservée, notamment de telle sorte qu'au moins temporairement une séquence de valeurs de courant numériques représentant un processus de coupure de la bobine, à savoir l'évolution temporelle du courant circulant dans la bobine après un passage de l'interrupteur électronique du premier état de commutation au deuxième état de commutation (courbe de courant de coupure) est enregistrée dans la mémoire de données et/ou qu'au moins temporairement une séquence de valeurs de courant numériques représentant un processus d'enclenchement de la bobine, à savoir l'évolution temporelle du courant circulant dans la bobine après un passage de l'interrupteur électronique du deuxième état de commutation au premier état de commutation (courbe de courant d'enclenchement), est enregistrée dans la mémoire de données.

5. Agencement de bobines selon l'une des revendications précédentes, pour lequel le circuit de commande et de surveillance est conçu pour déterminer, notamment à savoir pour calculer, à partir du signal de mesure de courant, notamment de manière périodique, une caractéristique dynamique du courant, à savoir une valeur caractéristique de l'évolution temporelle du courant circulant dans la bobine, notamment après un passage de l'interrupteur électronique du premier état de commutation au deuxième état de commutation ou après un passage de l'interrupteur électronique du deuxième état de commutation au premier état de commutation, notamment à savoir un taux de variation du courant ou un intervalle de temps nécessaire entre un instant de départ et l'atteinte d'une valeur de courant prédéfinie.

6. Agencement de bobines selon les revendications 4 et 5, pour lequel le circuit de commande et de surveillance est conçu pour déterminer la caractéristique dynamique du courant en utilisant des valeurs de courant numériques conservées dans la mémoire de données volatile (RAM), notamment en utilisant une séquence de valeurs de courant numériques (courbe de courant de coupure), laquelle séquence est conservée au moins temporairement dans la mémoire de données volatile (RAM) et laquelle séquence représente un processus de coupure de la bobine et/ou en utilisant une séquence de valeurs de courant numériques (courbe de courant d'enclenchement), laquelle séquence est conservée au moins temporairement dans la mémoire de données volatile (RAM) et laquelle séquence représente un processus d'enclenchement de la bobine.

7. Agencement de bobines selon la revendication précédente, pour lequel le circuit de commande et de surveillance est conçu pour déterminer la caractéristique dynamique du courant en additionnant un nombre prédéfini de valeurs de courant numériques, en commençant par une valeur de courant initiale représentant le courant circulant dans le circuit de la bobine à un instant de départ prédéfini et/ou déterminé en cours de fonctionnement.

8. Agencement de bobines selon l'une des revendications 5 à 7, pour lequel le circuit de commande et de surveillance est conçu pour déterminer la caractéristique dynamique du courant en intégrant une partie du signal de mesure du courant représentant l'évolution temporelle du courant sur un intervalle de temps prédéfini.

9. Agencement de bobines selon l'une des revendications 5 à 8, pour lequel le circuit de commande et de surveillance est conçu pour, lors du contrôle de la bobine, déterminer, notamment calculer, un écart entre la caractéristique dynamique du courant et une valeur de référence prédéfinie à cet effet, notamment mesurée au préalable et/ou enregistrée dans le circuit de surveillance.

10. Agencement de bobines selon la revendication précédente, pour lequel le circuit de commande et de surveillance est conçu pour, lors du contrôle de la bobine, comparer ledit écart à une valeur seuil (THR) prédéfinie à cet effet - notamment enregistrée au préalable dans le circuit de commande et de surveillance - et/ou à une limite d'intervalle correspondant à une gamme de valeurs associée à une bobine défectueuse, cette valeur seuil représentant le paramètre caractérisant l'évolution dans le temps du courant circulant dans la bobine.

11. Agencement de bobines selon la revendication précédente,
- pour lequel le circuit de commande et de surveillance comporte une mémoire de données non volatile (EEPROM), et
- pour lequel la valeur seuil (THR) est enregistrée dans la mémoire de données non volatile (EEPROM).

12. Agencement de bobines selon l'une des revendications précédentes, pour lequel le circuit d'exploitation (50) comprend une résistance de mesure (Rsens), intégrée notamment dans le circuit de la bobine et montée notamment en série avec ladite bobine, laquelle résistance est destinée à fournir une tension de mesure proportionnelle au courant électrique circulant dans le circuit de la bobine.

13. Agencement de bobines selon la revendication précédente,
- pour lequel le circuit d'exploitation comporte un convertisseur analogique-numérique destiné à numériser la tension de mesure fournie par la résistance de mesure, lequel circuit est notamment conçu pour délivrer la tension de mesure numérisée en tant que signal de mesure de courant ; et/ou
- le circuit d'exploitation étant conçu pour générer le signal de mesure de courant à l'aide de la tension de mesure ; et/ou
- le circuit d'exploitation étant conçu pour délivrer la tension de mesure sous forme de signal de mesure de courant, notamment numérisé.

14. Agencement de bobines selon l'une des revendications précédentes, comprenant en outre un ressort de rappel couplé mécaniquement à l'armature, lequel ressort est conçu pour exercer sur l'armature une force de rappel s'opposant à la force magnétique.

15. Interrupteur électromécanique (100), comprenant :
- un premier contact de commutation (101), notamment à ressort, lequel contact est mobile entre une première position de commutation (i) et une deuxième position de commutation (ii),
- un deuxième contact de commutation (102) ;
- et, pour actionner le premier contact de commutation, un agencement de bobines selon l'une des revendications précédentes ;
- l'armature (20) de l'agencement de bobines étant conçue pour, lors d'un passage de sa première position finale (l) à sa deuxième position finale (Il), déplacer le premier contact de commutation (101) de sa première position de commutation (i) à sa deuxième position de commutation (ii),
- le premier contact de commutation étant conçu pour être espacé, dans la première position de commutation, du deuxième contact de commutation en formant une distance d'air à haute impédance ou électriquement isolante,
- le premier contact de commutation étant conçu pour, dans la deuxième position de commutation, entrer en contact avec le deuxième contact de commutation en formant une liaison à faible résistance ou électriquement conductrice,
- et le circuit de commande et de surveillance étant conçu pour générer un message d'avertissement - signalant une défaillance de l'interrupteur électromécanique, notamment en raison d'une armature restant en première position finale aussi bien lors d'un signal de commutation présentant la première valeur de niveau de signal que lors d'un signal de commutation présentant la deuxième valeur de niveau de signal, ou en raison d'une armature restant en deuxième position finale aussi bien lors d'un signal de commutation présentant la première valeur de niveau de signal que lors d'un signal de commutation présentant la deuxième valeur de niveau de signal - si l'on détecte, à la suite de la vérification de la bobine effectuée à l'aide du signal de mesure de courant, un défaut de ladite bobine.

16. Transmetteur (Tr), comprenant :
- un interrupteur électromécanique (100) selon la revendication précédente ;
- ainsi qu'un circuit de mesure, notamment formé au moyen d'un microprocesseur et/ou alimenté par le circuit d'exploitation (50), lequel circuit de mesure est destiné à recevoir au moins un signal de capteur (s1), notamment électrique, dépendant d'une grandeur de mesure physique ou chimique et/ou représentant l'évolution dans le temps de ladite grandeur de mesure (x).

17. Transmetteur selon la revendication précédente,
- comprenant en outre : un boîtier de transmetteur, le circuit de mesure et l'interrupteur électromécanique étant placés tous deux à l'intérieur du boîtier de transmetteur ; et/ou
- comprenant en outre : un élément d'affichage (60) commandé par le circuit de commande et de surveillance (40), placé notamment à l'intérieur d'un boîtier de transmetteur, le circuit de commande et de surveillance (40) étant conçu pour transmettre un résultat de la vérification de la bobine, notamment sous la forme d'un signal d'état binaire ou numérique, à l'élément d'affichage (60), et l'élément d'affichage (60) étant conçu pour afficher ledit résultat de manière visible.

18. Transmetteur selon l'une des revendications 16 à 17,
- pour lequel le circuit de mesure est conçu pour générer un signal de commande, lequel est appliqué au circuit de commande et de surveillance, notamment en provoquant un changement du niveau du signal de commutation du premier niveau de signal au deuxième niveau de signal ou un changement du niveau du signal de commutation du premier niveau de signal au deuxième niveau de signal et/ou un signal de commande numérique, notamment pour générer le signal de commande en utilisant le signal du capteur et/ou en fonction d'au moins l'une des valeurs mesurées ; et/ou
- pour lequel le circuit de mesure est conçu pour déterminer, à l'aide du signal du capteur, des valeurs mesurées (s1) pour la grandeur de mesure ; et/ou
- pour lequel une sortie tout ou rien du transmetteur est formée au moyen de l'interrupteur électromécanique (100), notamment une sortie tout ou rien qui est conçue pour commuter un circuit électrique s'étendant en partie à l'extérieur du transmetteur.

19. Appareil de mesure, comprenant :
- un transmetteur (Tr) selon l'une des revendications 16 à 18 ;
- ainsi qu'un capteur (1000) couplé électriquement au circuit de mesure dudit transmetteur, lequel capteur est destiné à mesurer une grandeur physique et/ou chimique (x) variable dans le temps, notamment uniquement à l'intérieur d'une gamme de mesure prédéfinie, et lequel capteur est destiné à générer l'au moins un signal de capteur.
